# EUROPÄISCHE PATENTSCHRIFT

(11) **EP 1 504 273 B1**
(45) Veröffentlichungstag und Bekanntmachung des Hinweises auf die Patenterteilung: **12.10.2005**
(21) Anmeldenummer: 03720566.3
(22) Anmeldetag: 14.05.2003
(51) Int. Cl.: G01R 31/30, G01R 31/3185, G01R 31/3181, G01R 31/3183

(54) **SYSTEM ZUM TESTEN VON DIGITALBAUSTEINEN**
SYSTEM FOR TESTING DIGITAL COMPONENTS
SYSTEME POUR TESTER DES MODULES NUMERIQUES

(30) Priorität: 15.05.2002 DE 10221611
(43) Veröffentlichungstag der Anmeldung: 09.02.2005
(73) Patentinhaber: Infineon Technologies AG, 81669 München (DE)
(72) Erfinder: ARNOLD, Ralf, 85586 Poing (DE); HEINITZ, Matthias, 81739 München (DE); KÖPPE, Siegmar, 30880 Laatzen (DE); SCHÖBER, Volker, 30163 Hannover (DE)
(74) Vertreter: Banzer, Hans-Jörg
(86) Internationale Anmeldenummer: PCT/EP2003/005058
(87) Internationale Veröffentlichungsnummer: WO 2003/098243

(56) Entgegenhaltungen:
- US-A- 6 061 818
- BUSHNELL, AGRAWAL: "Essentials of Electronic Testing" 2000 , KLUWER XP002254834 Seite 489 -Seite 529
- POMERANZ T ET AL: "Built-in Generation of Weighted Test Sequences for Synchronous Sequential Circuits" CONFERENCE PROCEEDINGS, 27. März 2000 (2000-03-27), Seiten 298-303, XP010377483
- POMERANZ I ET AL: "Built-in test sequence generation for synchronous sequential circuits based on loading and expansion of test subsequences" DESIGN AUTOMATION CONFERENCE, 1999. PROCEEDINGS. 36TH NEW ORLEANS, LA, USA 21-25 JUNE 1999, PISCATAWAY, NJ, USA,IEEE, US, 21. Juni 1999 (1999-06-21), Seiten 754-759, XP010344037 ISBN: 1-58113-092-9

## Beschreibung

Die vorliegende Erfindung betrifft einen Digitalbaustein mit einer Selbsttestfunktion bzw. ein Verfahren zur Generierung eines solchen Digitalbausteins, sowie ein Verfahren bzw. eine Vorrichtung zum Testen von Digitalbausteinen.

Die betreffenden Digitalbausteine enthalten Funktionselemente, die in geeigneter Weise miteinander verschaltet sind, so dass die Digitalbausteine die geforderte Funktion erfüllen. Bei einfachen Digitalbausteinen ist es noch möglich, durch ihr von außen beobachtbares Verhalten die Funktionsfähigkeit zu testen. Sobald die Digitalbausteine jedoch komplexer werden und insbesondere synchrone Funktionselemente umfassen, können in deren Inneren sehr viele unterschiedliche Schaltzustände auftreten, die von außen nicht mehr überprüfbar sind. Aus diesem Grund ist es zum Testen von Digitalbausteinen bekannt, Funktionselemente innerhalb eines Digitalbausteins in Testeinheiten aufzuteilen und jede Testeinheit separat zu überprüfen. Dazu werden die Eingänge der Testeinheit mit einem Testmuster beaufschlagt und die sich dabei an den Ausgängen der Testeinheit ergebende Testmusterantwort ausgewertet. Zur Durchführung eines solchen Verfahrens ist es bekannt, einer Testeinheit ein Testmusterausgaberegister zuzuordnen, in das das Testmuster geladen werden kann und dessen Ausgänge die Eingänge der Testeinheit mit dem Testmuster beaufschlagen. Um die Funktion einer Testeinheit möglichst vollständig überprüfen zu können, werden die Eingänge der Testeinheit mit einer möglichst großen Anzahl an unterschiedlichen Kombinationen von Eingangssignalen beaufschlagt. Üblicherweise bewegt sich die Anzahl der Eingänge einer solchen Testeinheit im Bereich von einigen Hundert bis einigen Tausend. Dies bedeutet, dass bei Digitalsignalen die Anzahl der unterschiedlichen Möglichkeiten zur Beaufschlagung der Eingänge der Testeinheit wenigstens 2¹⁰⁰ ist zum Teil wesentlich darüber liegen kann. Um das Laden einer derart hohen Anzahl an Testmustern in die Testmusterausgaberegister bzw. das Auswerten der sich daraus jeweils ergebenden Testmusterantworten ist jedoch aus Zeitgründen keinesfalls möglich. In de Praxis begnügt man sich daher damit, bestimmte Testmuster auszuwählen, mit denen eine möglichst große Anzahl an möglichen Fehlern innerhalb der Testeinheit erkennbar sind. Nachteiligerweise erfordert dies zum einen ein kompliziertes Auswahlverfahren, bei dem der innere Aufbau der Testeinheit berücksichtigt werden muss. Darüber hinaus ist es mit solchen ausgewählten Testmustern häufig nicht möglich, alle Fehler innerhalb einer Testeinheit zu erkennen.

Der vorliegenden Erfindung liegt die Aufgabe zu Grunde, einen Digitalbaustein mit Selbsttestfunktion bzw. ein Verfahren zur Generierung eines solchen Digitalbausteins bzw. ein Verfahren zum Testen eines Digitalbausteins sowie eine Vorrichtung zum Testen eines Digitalbausteins zu schaffen, mit denen möglichst schnell eine möglichst umfassende Funktionsprüfung der Funktionselemente innerhalb des Digitalbausteins erreicht werden kann.

Erfindungsgemäß wird diese Aufgabe durch einen Digitalbaustein mit den Merkmalen des Anspruchs 1 bzw. 22, sowie ein Verfahren mit den Merkmalen des Anspruchs 28 bzw. 29, bzw. eine Vorrichtung mit den Merkmalen des Anspruchs 36 gelöst. Die Unteransprüche definieren jeweils bevorzugte und vorteilhafte Ausführungsformen der vorliegenden Erfindung.

Die vorliegende Erfindung nutzt die Erkenntnis, dass sich auf einen bestimmten Ausgang einer Testeinheit nur Änderungen an einer begrenzten Anzahl von Eingängen der Testeinheit auswirken. Dies bedeutet, dass zum Beobachten des Verhaltens eines Ausgangs der Testeinheit nur ein Teil der Eingänge der Testeinheit mit unterschiedlichen Testmustern beaufschlagt werden muss, da die übrigen Eingänge der Testeinheit sich ohnehin nicht auf diesen bestimmten Ausgang auswirken. Um diese Tatsache auszunutzen, wird erfindungsgemäß ein Testmusterausgaberegister zum Beaufschlagen der Eingänge der Testeinheit mit einem Testmuster geladen, das wenigstens zum Teil aus einer periodischen Folge eines Submusters besteht. Das Submuster ist insbesondere wesentlich kürzer als das Testmuster. Auf Grund der verringerten Länge des Submusters im Vergleich zu dem Testmuster ist es daher möglich, alle möglichen Kombinationen als Submuster zu verwenden, ohne dass die insgesamt für den Test des Digitalbausteins erforderliche Zeitdauer unzulässig hoch wird.

Von folgenden Dokumenten ist das Erzeugen eines Testmusters aus Submustern bekannt:
1.) US6061818A:
2.) POMERANZ I ET AL: "Built-in Generation of Weighted Test Sequences for Synchronous Sequential Circuits" CONFERENCE PROCEEDINGS, 27. März 2000,
   Seiten 298-303;
3.) POMERANZ I ET AL: "Built-in test sequence generation for synchronous sequential circuits based on loading and expansion of test subsequences", PROCEEDINGS of the 36^{TH} DESIGN AUTOMATION CONFERENCE, 21. Juni 1999, Seiten 754-759.

Diese Dokumente erwähnen allerdings nicht, dass die Periodizität des Testmusters durch eine Wirkanzahl bestimmt ist.

In aller Regel ist das Testmuster ein Binärwort, dessen einzelne Stellen den logischen Zustand beinhalten, mit dem ein Eingang der Testeinheit beaufschlagt wird. Wenn beispielsweise Submuster verwendet werden, deren Länge ≤ 30 bzw. 20 Bit ist, ergeben sich für die Anzahl an möglichen unterschiedlichen Submustern Zahlen im Bereich von 2²⁰ bis 2³⁰. In einem solchen Bereich ist es noch möglich, jede mögliche Kombination als Submuster zu verwenden. Die Erzeugung des Submusters und damit auch des Testmusters wird wesentlich vereinfacht, da keine Auswahl stattfinden muss. Daneben ist es jedoch auch möglich, bestimmte Submuster auszuwählen, mit denen bereits alle oder eine hinreichend große Anzahl der Fehler in der Testeinheit erkannt werden können. Auch in diesem Fall kann ein Vorteil erzielt werden, da sich auch bei dieser Vorgehensweise eine stark verringerte Anzahl an verschiedenen Testmustern ergibt.

Vorteilhafterweise werden für zumindest einige Ausgänge der betreffenden Testeinheiten des Digitalbausteins Wirkanzahlen bestimmt, wobei eine Wirkanzahl für einen bestimmten Ausgang einer Testeinheit die Anzahl der Eingänge dieser Testeinheit ist, an denen sich alleine Änderungen der Beaufschlagung auf den bestimmten Ausgang auswirken. Wenn beispielsweise die Wirkanzahl für einen bestimmten Ausgang einer Testeinheit 20 beträgt, so bedeutet dies, dass beim Beobachten eines bestimmten Ausgangs zum Testen von Funktionselementen ohnehin nur das Beaufschlagen dieser 10 Eingänge mit Testmustern sinnvoll sind, da eine Beaufschlagung anderer Eingänge ohnehin zu keiner Reaktion an dem bestimmten Ausgang führen. Vorteilhafterweise wird beim Entwurf des Digitalbausteins bereits darauf geachtet, dass die Ausgänge der einzelnen Testeinheiten möglichst geringe Wirkanzahlen aufweisen.

Die Länge der Submuster zum Aufbau der Testmuster kann sich insbesondere an der Wirkanzahl der einzelnen Testeinheiten orientieren. Bei einer Wirkanzahl von beispielsweise 10 werden vorteilhafterweise nur Submuster mit einer Länge von im Wesentlichen ≤ 10 verwendet. In der Regel treten bei den Testeinheiten eines Digitalbausteins unterschiedliche Wirkanzahlen auf. In einem solchen Fall kann die maximale Länge der Submuster in Abhängigkeit der maximalen Wirkanzahl oder einer durchschnittlichen Wirkanzahl bestimmt werden.

Die Submuster können vorteilhafterweise von einem rückgekoppelten Schieberegister erzeugt werden, bei dem der Eingang mit dem Ergebnis einer Exklusiv-Oder-Verknüpfung zwischen dem Ausgang und einem weiteren Schiebeglied des Schieberegisters beaufschlagt wird.

Zur Auswertung der Testmusterantwort an den Ausgängen der Testeinheit kommen verschiedene Verfahren in Frage. Zum einen kann die Testmusterantwort direkt an den Ausgängen der Testeinheit ausgewertet werden. Dazu muss eine entsprechende Einrichtung zum Auswerten der Testmustereinheit direkt an die Testeinheit angeschlossen sein. Daneben ist es auch möglich, die Testmusterantwort an den Ausgängen der Testmustereinheit zunächst in ein Testantwortleseregister zu übernehmen und aus diesem vorzugsweise seriell zu einer Auswerteeinheit zu übertagen. Zum Auswerten kann die Testmusterantwort verlustbehaftet oder ggf. auch nicht verlustbehaftet komprimiert werden. Ziel dabei ist es grundsätzlich, den Informationsgehalt der Testmusterantwort darauf zu reduzieren, ob die Testmusterantwort bei einem bestimmten auf die Eingänge der Testeinheit aufgeschalteten Testmuster auf eine korrekte Funktion der Testeinheit oder auf einen Fehler der Testeinheit hinweist. In aller Regel wird die Testmusterantwort daher verlustbehaftet komprimiert, da nur die Unterscheidung zwischen dem Fehlerfall und dem ordnungsgemäßen Funktionszustand der Testeinheit unterschieden werden muss. Dabei ist es auch möglich, Testantworten mehrerer aufgeschalteter Testmuster zusammen zu komprimieren.

Die Kompression einer Testantwort bzw. mehrerer Testantworten sollte dabei nicht so groß sein, dass trotz fehlerhafter Testeinheit das Ergebnis der Kompression durch Zufall dem Ergebnis der Kompression im ordnungsgemäßen Zustand der Testeinheit entsprechen kann. Wenn beispielsweise das Ergebnis einer verlustbehafteten Kompression ein 8-Bit-Wort ist und der ordnungsgemäße Zustand der Testeinheit durch eine bestimmte 8-Bit-Zahl charakterisiert wird, kann mit einer nicht allzu geringen Wahrscheinlichkeit ein fehlerhafter Zustand der Testeinheit zu einer anderen Testantwort führen, die jedoch nach der verlustbehafteten Kompression zu dem gleichen 8-Bit-Wert führt, wie er sich im fehlerfreien Fall ergeben würde. Aus diesem Grund darf die Kompression der Testmusterantwort bzw. mehrerer Testmusterantworten ein bestimmtes Maß nicht überschreiten.

Zur Auswertung einer oder mehrerer Testmusterantworten eignet sich vorteilhafterweise ein rückgekoppeltes Schieberegister aus mehreren Einzelregistern, bei dem der Eingang des Schieberegisters mit dem Ergebnis einer ersten Exklusiv-Oder-Verknüpfung zwischen dem Ausgang des Schieberegisters und dem Ausgang eines weiteren, insbesondere des vorletzten, Einzelregisters beaufschlagt wird. Wenigstens ein Einzelregister wird dabei mit dem Ergebnis einer zweiten Exklusiv-Oder-Verknüpfung zwischen dem Ausgangssignal des vorhergehenden Einzelregisters und dem Ausgangssignal eines Ausgangs der Testeinheit beaufschlagt. Im Fall des ersten Einzelregisters wird der Eingang des Einzelregisters mit dem Ergebnis einer Exklusiv-Oder-Verknüpfung zwischen dem Ergebnis der ersten Exklusiv-Oder-Verknüpfung und einem Ausgangssignal der Testeinheit beaufschlagt. Nach einer bestimmten Anzahl an Schiebeoperationen ergibt sich so als Zustand der Einzelregister eine Signatur, die von dem Startzustand der Einzelregister und den auf Grund der Exklusiv-Oder-Verknüpfungen berücksichtigten Ausgangssignale der Testeinheit abhängt. Diese Signatur stellt einen Binärwert dar, der charakteristisch für eine bestimmte Kombination der Ausgangssignale der Testeinheit bzw. einer Testantwort ist. Mit Hilfe einer derart aufgebauten Auswerteeinheit können auch mehrere zeitlich nacheinander anliegende Testantworten ausgewertet werden. Dazu können die Schiebeoperationen des Schieberegisters in dem Takt durchgeführt werden, in dem an den Ausgängen der Testeinheit neue Testantworten anliegen. Eine solche Vorgehensweise eignet sich insbesondere in den Fällen, in denen schnell unterschiedliche Testmuster auf die Testeinheit aufgeschaltet werden.

Für die zweite Exklusiv-Oder-Verknüpfung kann anstelle eines direkten Ausgangssignal eines Ausgangs einer Testeinheit auch das Ausgangssignal eines Schieberegisters verwendet werden, in das die Testantwort parallel eingelesen werden und zur Auswertung seriell ausgegeben werden kann. Bei jedem Schiebetakt eines solchen Schieberegisters muss das zur Auswertung verwendete rückgekoppelte Schieberegister mindestens eine Schiebeoperätion durchführen, um alle Stellen der Testantwort zu berücksichtigen.

Vorzugsweise wird das Testmuster in das Testmusterausgaberegister seriell geladen. Wenn in einer derartigen Ausgestaltung mit jedem Schiebetakt eines Schieberegisters als Testmusterausgaberegister eine an den Ausgängen der Testeinheit angeschlossene Auswerteeinheit die sich jeweils ergebende Testantwort auswerten kann, können die verschiedenen Submuster nacheinander in das Testmusterausgaberegister geschoben werden. Auf diese Weise wandern sozusagen die verschiedenen Submuster schrittweise an den Eingängen der Testeinheit vorbei, so dass jeder Abschnitt der Eingänge der Testeinheit nacheinander mit allen Submustern beaufschlagt wird. Da sich mit jedem Schiebetakt des Testmusterausgaberegisters die Beaufschlagung der Eingänge der Testeinheit ändert, ist es in diesem Fall vorteilhaft, die sich an den Ausgängen der Testeinheit ergebenden Testantworten mit jedem Schiebetakt des Testmusterausgaberegisters auszuwerten.

In einer vorteilhaften Weiterbildung wird das Testmusterausgaberegister sowohl zum Beaufschlagen der Eingänge der Testeinheit mit dem Testmuster als auch zum Einlesen der Testantwort verwendet. Dazu ist das Testmusterausgaberegister mit Eingängen und Ausgängen versehen, wobei die Eingänge des Testmusterausgaberegisters mit den Ausgängen der Testeinheit und die Ausgänge des Testmusterausgaberegisters mit den Eingängen der Testeinheit verbunden sind. Um die Daten in das Testmustereingaberegister einlesen und auslesen zu können, ist dieses als Schieberegister ausgebildet. Im Betrieb wird zunächst seriell in das Testmusterausgaberegister geschoben und wird später das Testmusterausgaberegister so angesteuert, dass es die an seinen Eingängen anliegende Testantwort übernimmt. Diese kann daraufhin seriell ausgelesen werden. Zur Durchführung dieser Operationen kann das Testmusterausgaberegister einen seriellen Eingang zum Einlesen des Testmusters, einen parallelen Ausgang zum Beaufschlagen der Eingänge einer Testeinheit mit dem Testmuster, einen parallelen Eingang zum Einlesen der Testantwort einer anderen Testeinheit und einen seriellen Ausgang zum seriellen Ausgeben der Testantwort aufweisen.

Vorteilhafterweise wird die Testantwort beim Hinausschieben aus dem Testmusterausgaberegister ausgewertet. Dazu kann der Ausgang des Testmusterausgaberegisters auf einen Eingang einer Auswerteeinheit aufgeschaltet sein, an den andernfalls ein Ausgang der Testeinheit direkt angeschlossen werden kann. Die Auswerteeinheit kann ein rückgekoppeltes Schieberegister der zuvor beschriebenen Art aufweisen, wobei das rückgekoppelte Schieberegister der Auswerteeinheit im gleichen Takt wie das Schieberegister des Testmusterausgaberegister angesteuert wird. Dabei ist es auch möglich, eine Auswerteeinheit mit einem rückgekoppelten Schieberegister mit mehreren Eingängen für auszuwertende Daten zu verwenden und die Testmusterantworten aus mehreren Testmusterausgaberegistern gleichzeitig zu den verschiedenen Eingängen des rückgekoppelten Schieberegisters zu leiten. In einem derartigen Fall wird in der Auswerteeinheit eine Signatur in Abhängigkeit mehrerer gleichzeitig in die Auswerteeinheit übertragener Testantworten gebildet.

Wenn ein Testmusterausgaberegister zum Einlesen und seriellen Ausgeben einer Testantwort verwendet wird, bedeutet dies in aller Regel, dass das Testmuster zum Beaufschlagen der Eingänge der Testeinheit von einer Testantwort überschrieben wird. Daher wird vorteilhafterweise in einem solchen Fall das Testmusterausgaberegister vor der Übernahme einer Testantwort erst vollständig mit einem neuen Testmuster geladen. Um ein solches Überschreiben des Testmusters im Testmusterausgaberegister zu vermeiden, kann ein Doppelschieberegister mit zwei Strängen vorgesehen sein, beim dem ein Strang mit dem Testmuster geladen und der andere Strang zum Übernehmen und seriellen Ausgeben der Testantwort verwendet wird.

Vorteilhafterweise werden als Testmusterausgaberegister Funktionselemente der Testeinheit verwendet, die zur Durchführung des Tests des Digitalbausteins zu einem Testmusterausgaberegister verschaltbar sind. Auf diese Weise können ohnehin vorhandene Funktionselemente der Testeinheit zur Bereitstellung der Testmusterausgaberegister verwendet werden. Ggf. können dazu nicht völlig geeignete Funktionselemente mit entsprechenden Funktionalitäten erweitert werden, so dass der für die Bereitstellung der Testmusterausgaberegister erforderlich Aufwand durch Nutzung von Funktionselementen der Testeinheit verringert werden kann. Gleiches gilt für die Komponenten einer Auswerteeinheit oder eines Testantwortleseregisters zum Aufnehmen und Weiterleiten der Testantwort.

Ein Testmuster besteht wenigstens zum Teil aus einer periodischen Folge eines bestimmten Submusters oder ausschließlich aus einer periodischen Folge des bestimmten Submusters. Das Submuster kann dabei entweder aus einem Speicher abgerufen werden, in dem eine Auswahl an Submustern gespeichert ist, oder systematisch erzeugt werden. Dazu kann beispielsweise ein digitaler Zähler verwendet werden, der nach oben oder unten zählt und dessen Zählerstand als Submuster verwendet wird.

Zur Durchführung der Funktionsprüfung des Digitalbausteins ist eine Selbsttesteinheit im Digitalbaustein vorgesehen. In dieser Selbsttesteinheit kann entweder das Submuster bzw. das Testmuster selbständig erzeugt werden oder es ist eine Möglichkeit zur Steuerung der Selbsttesteinheit von außerhalb des Digitalbausteins vorgesehen. In letzterem Fall kann entweder ein Submuster oder Steuersignale zur Erzeugung des Submusters an die Selbsttesteinheit im Digitalbaustein übertragen werden, so dass diese das Testmuster erzeugt und in die Testmusterausgaberegister lädt. Ebenso muss die Testmusterantwort nicht notwendigerweise innerhalb des Digitalbausteins ausgewertet werden. Beispielsweise kann die Testmusterantwort nach außen übertragen werden und außerhalb des Digitalbausteins beispielsweise durch Kompression ausgewertet werden.

Zur Auswertung der Reaktion der Testeinheit auf das Testmuster kann auch das Electron-Beam-Verfahren angewendet werden. Dabei können elektrische Potenziale auf dem Digitalbaustein berührungslos erfasst werden. Ein Vorteil bei diesem Verfahren besteht darin, dass innerhalb des Digitalbausteins auch Punkte überwacht werden können, die mit keinem Ausgang einer Testeinheit verbunden sind.

Die verwendeten Testmuster können in Bezug auf ihrem periodischen Teil auch eine variable Periodizität aufweisen. Dies wird mit unterschiedlich langen Submustern erreicht. Um eine solche Periodizität zu erreichen, können insbesondere rückgekoppelte Schieberegister verwendet werden. In einer vorteilhaften Ausführungsform wird ein solches Submusterschieberegister von einem Teil eines auch als Testmusterausgaberegister verwendeten Schieberegister verwendet. Dabei muss bei unterschiedlich langen Submustern jedoch eine Möglichkeit geschaffen sein, eine variable Periodizität des Submusterschieberegisters zu erreichen. Beispielsweise kann dazu ein Multiplexer verwendet werden, der den Ausgang des Testmusterausgaberegisters auf die Eingänge verschiedener Einzelregister des Submusterschieberegisters rückkoppeln kann, wobei gleichermaßen der Multiplexer den Eingang des Submusterschieberegisters mit verschiedenen Ausgängen von Einzelregistern verbinden kann. So wie das Testmusterausgaberegister kann auch das Submusterschieberegister von Funktionselementen des Digitalbausteins gebildet werden, die zum Testen des Digitalbausteins zu dem Submusterschieberegisters umschaltbar sind.

Vorteilhafterweise wird der Test des Digitalbausteins mit möglichst kurzen Submustern begonnen, da diese eine geringere Anzahl an verschiedenen Möglichkeiten zulassen. Dabei kann die Länge der Submuster schrittweise erhöht werden bis zu einem Wert, der keine zusätzlichen Fehlererkennungsmöglichkeiten verschafft, und insbesondere bis zu einem Wert der Wirkanzahl der Testeinheiten entspricht. Wenn bei einer solchen schrittweisen Erhöhung der Länge der Submuster jede mögliche Kombination innerhalb des Submusters verwendet wird, können die Längen der Submuster entsprechend der Primzahlenreihe gewählt werden, da Submuster, deren Länge ganzzahlig teilbar ist, notwendigerweise durch die periodische Folge kürzerer Submuster bereits dargestellt worden sind. Das Vorangegangene gilt jedoch nur für Testmuster, die aus einer periodischen Folge von Submustern erzeugt werden.

Die Erfindung richtet auch auf ein Verfahren zur Generierung eines solchen Digitalbausteins. Die Generierung von Digitalbausteinen findet größtenteils rechengeschützt statt, wobei dabei vorgesehen sein kann, die Implementierung der Teile, die zum Aufbau eines erfindungsgemäßen Digitalbausteins erforderlich sind, zu speichern, und auf diese Weise durch einfaches Hinzfügen dieser Funktion bei der Generierung rechengestützt einen beliebigen Digitalbaustein mit der erfindungsgemäßen Selbsttestfunktion auszurüsten.

Die Erfindung wird nachfolgend anhand bevorzugter Ausführungsbeispiele unter Bezugnahme auf die beigefügten Zeichnungen näher erläutert.
Figur 1 zeigt den Aufbau eines Digitalbausteins mit Selbsttestfunktion gemäß einem ersten Ausführungsbeispiel der vorliegenden Erfindung,
Figur 2 zeigt den Aufbau eines Digitalbausteins mit Selbsttestfunktion gemäß einem zweiten Ausführungsbeispiel der vorliegenden Erfindung,
Figur 3 zeigt den Aufbau eines Digitalbausteins mit Selbsttestfunktion gemäß einem dritten Ausführungsbeispiel der vorliegenden Erfindung,
Figur 4 zeigt den Aufbau einer Auswerteeinheit zur Verwendung in einem Digitalbaustein gemäß einem der Ausführungsbeispiele der vorliegenden Erfindung,
Figur 5 zeigt einen Teil eines Digitalbausteins gemäß einem vierten Ausführungsbeispiel der vorliegenden Erfindung, und
Figur 6 zeigt den Aufbau eines Digitalbausteins gemäß einem fünften Ausführungsbeispiel der vorliegenden Erfindung.

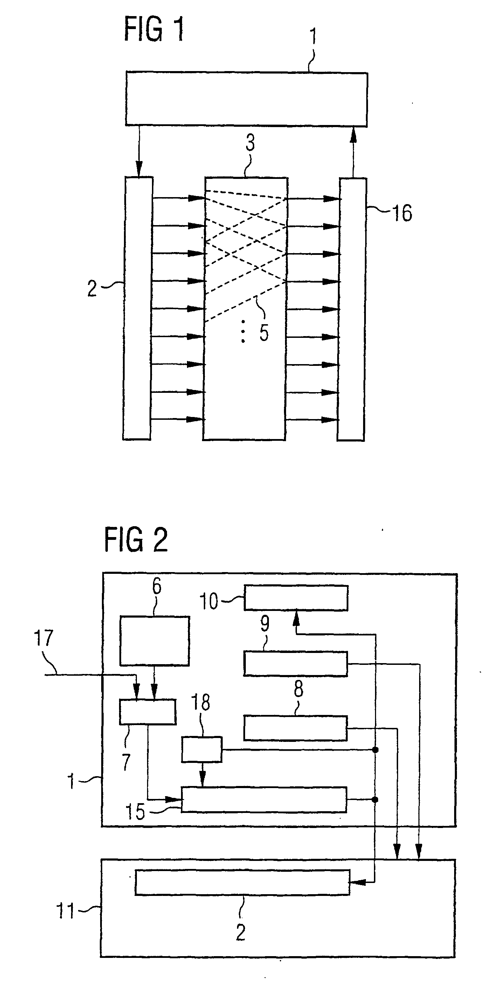

In Figur 1 ist schematisch der Aufbau eines Digitalbausteins gemäß einem ersten Ausführungsbeispiel der vorliegenden Erfindung dargestellt. In diesem ersten Ausführungsbeispiel umfasst der Digitalbaustein eine Testeinheit 3 mit Funktionselementen, ein Testmusterausgaberegister 2 und eine Auswerteeinheit 16. Zusätzlich ist eine Selbsttesteinheit 1 vorgesehen, die in einer Selbsttestphase des Digitalbausteins die zum Selbsttest notwendigen Funktionen steuert. Das Testmusterausgaberegister 2 ist ein Schieberegister mit parallelem Ausgang und seriellem Eingang, wobei der parallele Ausgang des Testmusterausgaberegisters 2 zahlreiche Ausgangsleitungen umfasst, die jeweils einen Eingang der Testeinheit 3 beaufschlagen. Der serielle Eingang des Testmusterausgaberegisters 2 ist mit der Selbsttesteinheit 1 verbunden, damit diese ein Testmuster in Form eines Digitalwerts, insbesondere eines Binärwerts, seriell in das Testmusterausgaberegister 2 laden kann. Die auf der rechten Seite befindlichen Ausgänge der Testeinheit 3 sind mit Eingängen der Auswerteeinheit 16 verbunden. Die Komponenten des Testmusterausgaberegisters 2 und/oder der Auswerteeinheit 16 und/oder der Selbsttesteinheit 1 können Funktionselemente des Digitalbausteins sein, die außerhalb der Selbsttestphase zum normalen Betrieb des Digitalbausteins verwendet werden und in der Selbsttestphase so umgeschaltet werden, dass sie das Testmusterausgaberegister 2 bzw. die Auswerteeinheit 16 bzw. die Selbsttesteinheit 1 bilden. Innerhalb der Testeinheit 3 sind zahlreiche Funktionselemente miteinander verschaltet, wobei die Eingänge der Testeinheit 3 von außen ansprechbaren Eingängen der Funktionselemente der Testeinheit 3 entsprechen und die Ausgänge der Testeinheit 3 von außen beobachtbaren Ausgängen der Funktionselemente der Testeinheit 3 entsprechen. Die Funktionselemente innerhalb der Testeinheit 3 können Gatter oder Schaltglieder sein. Wenn man das Verhalten eines Ausgangs der Testeinheit 3 in Abhängigkeit der Beaufschlagung der Eingänge der Testeinheit 3 beobachtet, kann festgestellt werden, dass die Auswirkungen der verschiedenen Eingänge der Testeinheit 3 auf einem bestimmten Ausgang der Testeinheit 3 Wirkkegel 5 bilden, deren Spitzen jeweils von dem bestimmten Ausgang der Testeinheit 3 gebildet werden und deren Basis jeweils eine bestimmte Wirkanzahl von Eingängen der Testeinheit 3 umfassen. Dies bedeutet für einen bestimmten Ausgang der Testeinheit 3, dass auf diesen bestimmten Ausgang sich nur Eingänge der Testeinheit 3 auswirken können, die innerhalb des entsprechenden Wirkkegels 5 liegen oder anders ausgedrückt, dass sich nur Änderungen an einer bestimmten Wirkanzahl von Eingängen der Testeinheit 3 auf den bestimmten Ausgang auswirken können. Für die Funktionsprüfung der Funktionselemente innerhalb der Testeinheit 3 bedeutet dies, dass bei Betrachtung eines einzelnen Ausgangs der Testeinheit 3 nicht alle Eingänge der Testeinheit 3 mit wechselnden Signalen beaufschlagt werden müssen, sondern nur eine der Wirkanzahl für den bestimmten Ausgang entsprechenden Anzahl an Eingängen.

Um dies auszunutzen, wird das Testmuster zum Beaufschlagen der Eingänge der Testeinheit 3 aus einem oder mehreren Submustern gebildet, dessen Länge bzw. deren Längen insbesondere nicht die maximale oder durchschnittliche Wirkanzahl für die Ausgänge der Testeinheit 3 übersteigen. Dabei sind die Ausgänge des Testmusterregisters 2 mit den Eingängen der Testeinheit 3 derart verschaltet, dass bezogen auf die Schieberichtung des als Schieberegister ausgebildeten Testmusterausgaberegisters 2 die zu den einzelnen Wirkkegeln 5 jeweils gehörenden Eingänge der Testeinheit 3 möglichst nahe zusammenliegen. Da durch das serielle Laden des Testmusterausgaberegisters 2 die einzelnen Stellen des Submusters bzw. der Submuster an den Ausgängen des Testmusterausgaberegisters 2 in dessen Schieberichtung nebeneinander zu liegen kommen, kann auf diese Weise mit möglichst kurzen Submustern eine vollständige Beaufschlagung der Wirkkegel 5 erreicht werden. Bei dem in Figur 1 dargestellten Ausführungsbeispiel ist nur ein Teil der Eingänge bzw. Ausgänge der Testeinheit 3 dargestellt. Tatsächlich bewegt sich die Anzahl der Eingänge bzw. Ausgänge der Testeinheit 3 im Bereich von 100 und darüber. Darüber hinaus kann der Digitalbaustein auch weitere Testeinheiten 3 aufweisen, denen jeweils ein Testmusterausgaberegister 2 und eine Auswerteeinheit 16 zugeordnet sind, die jeweils mit der Selbsttesteinheit 1 verbunden sind.

Zum Testen der Funktionselemente innerhalb der Testeinheit 3 werden innerhalb der Selbsttesteinheit 1 wechselnde Testmuster erzeugt, deren Länge der Anzahl der Eingänge der Testeinheit 3 entspricht und die nacheinander in das Testmusterausgaberegister 2 geladen werden. Die Testmuster werden ausgehend von Submustern erzeugt, wobei ein Testmuster entweder teilweise oder vollständig eine periodische Folge eines bestimmten Submusters sein kann oder auch eine Folge verschiedener Submuster sein kann. Dies hängt im Wesentlichen davon ab, in welchem Takt die Auswerteeinheit 16 die an den Ausgängen der Testeinheit 3 anliegende Testantwort auswerten kann.

Im Folgenden wird der Fall betrachtet, dass die Auswerteeinheit 16 bei jedem Schiebetakt des Testmusterausgaberegisters 2, bei dem eine veränderte Beaufschlagung der Eingänge der Testeinheit 3 erreicht werden kann und sich folglich auch eine geänderte Testmusterantwort an den Ausgängen einstellen kann, die Testmusterantwort auswerten kann. In diesem Fall besteht die Möglichkeit, die verschiedenen Submuster nacheinander in das Testmusterausgaberegister 2 seriell zu laden, so dass die verschiedenen Submuster nacheinander an den Eingängen der Wirkkegel 5 vorbeiwandern, wobei diese Schiebeoperationen solange fortgesetzt werden, bis das letzte Submuster durch das Testmusterausgaberegister 2 vollständig hindurchgeschoben worden ist. Dabei ist es selbstverständlich auch möglich, einzelne oder alle Submuster beliebig oft zu wiederholen, so dass beispielsweise jedes Submuster ein paar Mal hintereinander aufeinanderfolgend in das Testmusterausgaberegister 2 geladen wird, bis in gleicher Weise mit dem nächsten Submuster verfahren wird. Sinnvollerweise wird ein Submuster höchstens so oft wiederholt, bis das gesamte Testmusterausgaberegister 2 mit diesem Submuster gefüllt ist, da eine öftere Wiederholung dieses Submusters zu keiner andersartigen Beaufschlagung der Eingänge der Testeinheit 3 führen würde. Bei dieser Vorgehensweise ergibt sich bei jedem Schiebetakt des Testmusterausgaberegisters 2 eine geänderte Beaufschlagung der Testeinheit 3 und kann sich daher eine geänderte Testantwort an den Eingängen der Auswerteeinheit 16 ergeben. Daher wertet die Auswerteeinheit 16 mit jedem Schiebetakt des Testmusterausgaberegisters 2 die Testantwort der Testeinheit 3 aus. Die verschiedenen sich dabei ergebenden Testantworten werden von der Auswerteeinheit 16 verlustbehaftet zu einer Signatur komprimiert, die ein Digitalwert ist. Diese Signatur wird von der Auswerteeinheit 16 insbesondere seriell zur Selbsttesteinheit 1 übertragen, so dass diese in Abhängigkeit der in das Testmusterausgaberegister 2 geladenen Daten beurteilen kann, ob die dabei erhaltene Signatur auf eine ordnungsgemäße Funktion der Funktionselemente innerhalb der Testeinheit 3 schließen lässt. Dabei wird für die gewählte Folge an Submustern zur Beaufschlagung der Testeinheit 3 vorzugsweise vorab die sich durch die Komprimierung durch eine bestimmte Auswerteeinheit 16 ergebende Signatur bei ordnungsgemäßer Funktion der Testeinheit 3 ermittelt und in der Selbsttesteinheit 1 abgelegt. Diese braucht dann nur noch die von der Auswerteeinheit 16 gelieferte Signatur mit der abgelegten Soll-Signatur vergleichen und so bei Übereinstimmung den ordnungsgemäßen Zustand der Testeinheit 3 festzustellen. Bei dieser Art der Auswertung innerhalb der Auswerteeinheit 16 erfolgt die Signaturbildung darin taktgesteuert, wobei der Takt zur Signaturbildung innerhalb der Auswerteeinheit 16 mit dem Schiebetakt für das Testmusterausgaberegister 2 übereinstimmt.

Weiterhin ist es jedoch auch möglicht, für jeden Schiebetakt des Testmusterausgaberegisters 2 mehrere Takte zur Signaturbildung innerhalb der Auswerteeinheit 16 durchzuführen. Nachteiligerweise verlangsamt dies jedoch den Funktionstest des Digitalbausteins. Die Auswerteeinheit 16 kann u.U. auch so eingerichtet sein, dass sie selbst bereits die gewonnene Signatur oder die eingelesenen Testantworten dahingehend überprüfen kann, ob die Funktionselemente innerhalb der Testeinheit 3 korrekt funktionieren.

Als nächstes soll der Fall betrachtet werden, dass die Auswerteeinheit 16 selbst keine Komprimierung der Testantwort durchführen kann, sondern nur ein einfaches Schieberegister zum seriellen Übertragen der Testantwort in die Selbsttesteinheit 1 ist. In diesem Fall muss bei einer Änderung der Testantwort zuerst der gesamte Inhalt der Auswerteeinheit 16 in die Selbsttesteinheit 1 übertragen werden, bevor eine geänderte Testantwort erzeugt werden darf, da ansonsten Informationen verloren gehen würden. Dies bedeutet, dass bei jeder Änderung der Beaufschlagung der Eingänge der Testeinheit 3 die sich ergebende Testantwort in die Auswerteeinheit 16 übernommen und vollständig ausgelesen werden muss. In diesem Fall ist es vorteilhaft, vor jedem vollständigen Auslesen des Inhalts der Auswerteeinheit 16 das Testmusterausgaberegister 2 vollständig mit einem neuen Testmuster zu laden. Vorzugsweise wird jedes neue Testmuster als periodische Folge eines bestimmten Submusters gebildet. Dies bedeutet, dass die vorhandenen Submuster nacheinander zur Erzeugung entsprechender Testmuster verwendet werden, die zum Teil oder insbesondere vollständig eine periodische Folge eines bestimmten Submusters sind. Diese Testmuster werden von der Selbsttesteinheit 1 nacheinander in das Testmusterausgaberegister 2 geladen, wobei die Auswerteeinheit 16 die sich ergebende Testantwort übernimmt und der Selbsttesteinheit 1 überträgt, sobald das Testmusterausgaberegister 2 mit einem Testmuster geladen ist. Die Komprimierung der Testantwort geschieht in diesem Fall in der Selbsttesteinheit 1.

Die Submuster können in den vorangegangenen Fällen auf verschiedene Weisen erzeugt werden. Zum einen kann innerhalb der Selbsttesteinheit 1 ein Speicher zur Speicherung der zu verwendenden Submuster vorhanden sein. Darüber hinaus kann die Selbsttesteinheit 1 einen digitalen Zähler enthalten, dessen Zählerstände als Submuster verwendet werden. Dieses Verfahren lässt sich mit besonders geringem Aufwand durchführen und eignet sich insbesondere bei kurzen Submustern, bei denen sämtliche Kombinationen der einzelnen Stellen verwendet werden sollen.

In Figur 2 ist ein Digitalbaustein gemäß einem zweiten Ausführungsbeispiel der vorliegenden Erfindung dargestellt. Darin bezeichnet 1 wieder die Selbsttesteinheit. Die zu testenden Komponenten des Digitalbausteins sind in einem Funktionselementblock 11 zusammengefasst. Innerhalb des Funktionselementblocks 11 befindet sich exemplarisch ein Testmusterausgaberegister 2 zur Beaufschlagung einer nicht dargestellten Testeinheit 3. Weiterhin umfasst der Funktionselementblock 11 eine nicht dargestellte Auswerteeinheit zum Auswerten der Testantworten. Das Zusammenwirken zwischen dem Testmusterausgaberegister 2, der Testeinheit und der Auswerteeinheit kann auf die bei dem ersten Ausführungsbeispiel beschriebenen Weisen erfolgen.

Im Folgenden soll auf den Aufbau der Selbsttesteinheit 1 eingegangen werden. Diese weist ein Submusterschieberegister 15 auf, in dem ausgehend von einem geladenen Submuster durch Wiederholung Testmuster erzeugt werden können. Dazu weist das Submusterschieberegister 15 links einen Eingang und rechts einen Ausgang auf, der über einen Multiplexer 18 steuerbar rückgekoppelt werden kann. Dazu ist das Submusterschieberegister 15 derart mit dem Multiplexer 18 verschaltet, dass der Multiplexer 18 den Ausgang des Submusterschieberegisters 15 auf den Eingang eines innerhalb des Submusterschieberegisters 15 auswählbaren Schiebeelements rückkoppeln kann.

Um ein Testmuster zu erzeugen, wird das Submusterschieberegister 15 mit einem Submuster geladen und mit dem Multiplexer 18 eine Periodizität eingestellt, die der Länge des Submusters entspricht. Sobald nun das Submusterschieberegister 15 weiter in Schieberichtung betrieben wird, wird das zuvor geladene Submuster auf Grund der Rückkopplung beliebig oft wiederholt. Über den Ausgang des Submusterschieberegisters wird die so erhaltene periodische Folge des Submusters in das Testmusterausgaberegister 2 geladen. Als Quelle für das Submuster kann ein Speicher 6 dienen, der innerhalb der Selbsttesteinheit 1 angeordnet ist. Darüber hinaus ist eine Submustereingangsleitung 17 vorgesehen, die zusammen mit dem Ausgang des Speichers 6 zu einem Multiplexer 7 führt, mit dem zur Beaufschlagung des Submusterschieberegisters 15 entweder ein aus dem Speicher 6 stammendes Submuster oder ein von außen über die Submustereingangsleitung 17 zugeführtes Submuster weitergeleitet werden kann.

Grundsätzlich kann an Stelle des Speichers 6 auch ein rückgekoppeltes Schieberegister verwendet werden, um die Submuster zu erzeugen, wobei der Eingang des Schieberegisters mit dem Ergebnis einer Exklusiv-Oder-Verknüpfung zwischen dem Ausgang und einem weiteren Schiebeglied des Schieberegisters beaufschlagt wird und der Zustand des Schieberegisters als Submuster parallel oder seriell zum Submusterschieberegister 15 übertragen wird.

Zur Überwachung des Ladevorgangs des Testmusters in das Testmusterausgaberegister 2 ist innerhalb der Selbsttesteinheit 1 ein Zähler 10 vorgesehen, der die am Ausgang des Submusterschieberegisters 15 herausgeschobenen Bits mitzählt. Darüber hinaus weist die Selbsttesteinheit 1 einen Teststeuerblock 8 auf, der den Funktionselementblock 11 in den Testmodus versetzen kann. Bei diesem Versetzen in den Testmodus können beispielsweise bestimmte Funktionselemente innerhalb des Funktionselementblock 11 zu einem Testmusterausgaberegister 2 bzw. zu einer Auswerteeinheit umgeschaltet werden, wobei zusätzlich die zum Selbsttest erforderlichen Verbindungen hergestellt werden können.

Weiterhin ist in der Selbsttesteinheit 1 ein Testantwortübernahmeblock 9 vorgesehen, der die Übernahme einer Testantwort in eine Auswerteeinheit steuert, sofern die verwendete Auswerteeinheit eine derartige Übernahmesteuerung benötigt.

Der Selbsttest des Digitalbausteins erfolgt dabei wie folgt. Zunächst wird von der Selbsttesteinheit 1 der Funktionselementblock 11 mittels des Teststeuerblocks 8 in den Testmodus versetzt. Nach Auswählen der gewünschten Quelle für das verwendete Submuster mittels des Multiplexers 7 wird entweder über die Submustereingangsleitung 17 oder aus dem Speicher 6 ein Submuster in das Submusterschieberegister 15 geladen. Abhängig von der Länge des verwendeten Submusters wird mittels des Multiplexers 18 die erforderliche Periodizität eingestellt. Das Submusterschieberegister 15 wird anschließend solange im Schiebebetrieb weiterbetrieben, bis das Testmusterausgaberegister 2 vollständig mit einer periodischen Folge des Submusters gefüllt ist. Dies wird mit Hilfe des Zählers 10 überwacht. Anschließend wird ggf. mittels des Testantwortübernahmeblock 9 ein geeigneter Steuerbefehl an den Funktionselementblock 11 geleitet, in dem daraufhin wenigstens eine Testantwort in eine Auswerteeinheit übernommen wird. Die Auswertung der Testantwort kann entweder mittels einer geeignet ausgestalteten Auswerteeinheit innerhalb des Funktionselementblocks 11 stattfinden oder auch außerhalb durchgeführt werden. Dazu kann eine nicht dargestellte Verbindung zwischen dem Funktionselementblock 11 und der Selbsttesteinheit 1 vorgesehen sein, über die die wenigstens eine Testantwort in die Selbsttesteinheit 1 zur dortigen Auswertung übertragen werden kann. Weiterhin besteht die Möglichkeit, die wenigstens eine Testantwort entweder direkt oder über die Selbsttesteinheit 1 von außerhalb des Digitalbausteins auszulesen und dort auszuwerten. Letzteres bietet sich insbesondere in den Fällen an, in denen das verwendete Submuster über die Submustereingangsleitung 17 von außen zugeführt worden ist.

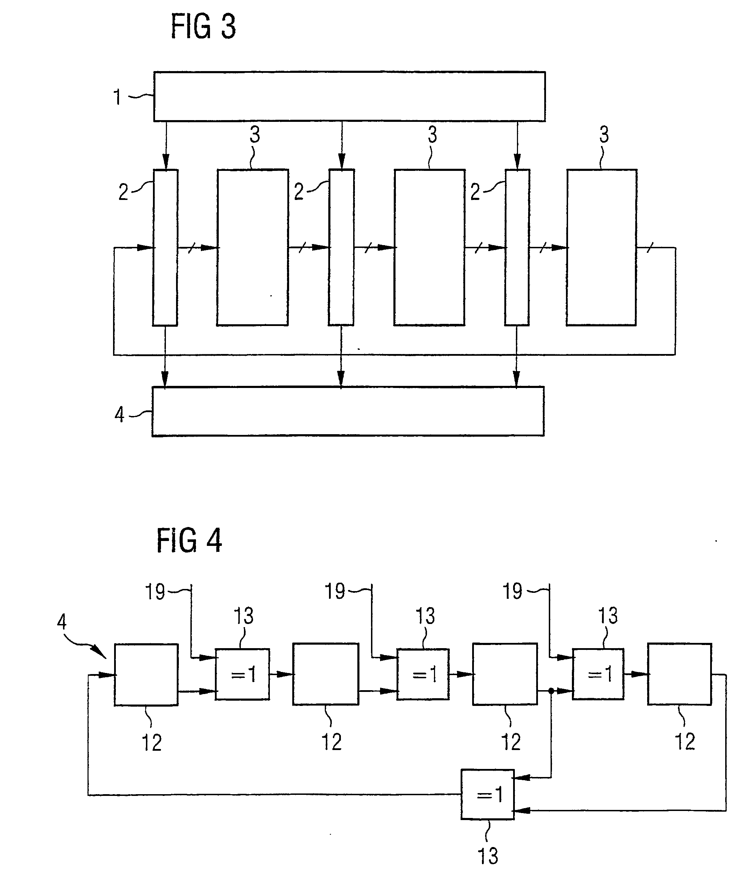

Figur 3 zeigt ein drittes Ausführungsbeispiel der vorliegenden Erfindung, bei dem insgesamt drei Testeinheiten 3 und drei Testmusterausgaberegister 2 vorgesehen sind. Die Testmusterausgaberegister 2 sind in diesem Ausführungsbeispiel als Schieberegister ausgestaltet und derart eingerichtet, dass sie jeweils einen seriellen Ausgang, einen seriellen Eingang, einen parallelen Ausgang und einen parallelen Eingang aufweisen. Die parallelen Eingänge der Testmusterausgaberegister 2 sind jeweils mit einem Ausgang einer Testeinheit 3 verbunden, so dass die Testantworten der Testeinheiten 3 in die Testmusterausgaberegister 2 übernommen werden können. Die parallelen Ausgänge der Testmusterausgaberegister 2 sind wie zuvor beschrieben mit den Eingängen der Testeinheiten 3 zur Beaufschlagung mit einem Testmuster verbunden. Die seriellen Eingänge sind ebenso wie zuvor beschrieben mit der Selbsttesteinheit 1 verbunden und die seriellen Ausgänge mit einer Auswerteeinheit 4 verbunden. Bei diesem Ausführungsbeispiel wird jedes Testmusterausgaberegister 2 sowohl zum Beaufschlagen der Eingänge einer Testeinheit 3 in einem Testmuster als auch zur Übernahme der Testantwort verwendet. Da jedoch beim Übernehmen der Testantworten in die Testmusterausgaberegister 2 die zuvor darin enthaltenen Inhalte überschrieben werden, ist es in diesem Ausführungsbeispiel vorteilhaft, zunächst die Testmusterausgaberegister 2 vollständig mit einem neuen Testmuster zu laden und anschließend die sich dabei ergebenden Testantworten durch geeignete Ansteuerung der Testmusterausgaberegister 2 darin zu übernehmen. Die in die Testmusterausgaberegister 2 geladenen Testmuster sind vorteilhafterweise gleich, können aber auch unterschiedlich sein.

Zum Auslesen der in die Testmusterausgaberegister 2 übernommenen Testantworten der Testeinheiten 3 werden diese im Schiebebetrieb betrieben, so dass die Testantworten seriell zur Auswerteeinheit 4 übertragen werden. Die Auswerteeinheit 4 wird dabei so betrieben, dass mit jedem Schiebetakt der Testmusterausgaberegister 2, mit dem die Testantworten in die Auswerteeinheit 4 übertragen werden, die Testeinheit 4 das neu hineingeschobene Bit mitkomprimiert.

In Figur 4 ist ein möglicher Aufbau der Auswerteeinheit 4 dargestellt. Die dargestellte Auswerteeinheit 4 wird von einem rückgekoppelten Schieberegister aus mehreren einzelnen Schiebegliedern 12 bzw. Einzelregistern 12 gebildet. Die Schieberichtung ist im dargestellten Fall von links nach rechts. Der Eingang des ersten Einzelregisters 12, das links dargestellt ist, wird dabei vom Ergebnis einer ersten Exklusiv-Oder-Verknüpfung zwischen den Ausgängen des letzten und des vorletzten Einzelregisters 12 beaufschlagt. Diese erste Exklusiv-Oder-Verknüpfung wird mit Hilfe eines Exklusiv-Oder-Gatters 13 durchgeführt, dessen zwei Eingänge mit dem Ausgang des letzten bzw. des vorletzten Einzelregisters 12 verbunden sind. Zusätzlich sind Exklusiv-Oder-Gatter 13 vorgesehen, die zwischen zwei aufeinanderfolgenden Einzelregistern 12 zwischengeschaltet sind, wobei sie derart geschaltet sind, dass der Eingang eines Einzelregisters 12 mit dem Ergebnis einer zweiten Exklusiv-Oder-Verknüpfung zwischen dem Ausgang des vorhergehenden Einzelregisters 12 und einem über eine Eingangsleitung 19 zugeführten Signal, das dem auszuwertenden Signal entspricht, beaufschlagt wird. An die Eingangsleitungen 19 können beispielsweise direkt die Ausgänge einer Testeinheit angeschlossen werden oder der serielle Ausgang eines Schieberegisters, in das die Testantwort übernommen worden ist und aus dem die Testantwort seriell zur Auswerteeinheit weitergeleitet wird. Die Auswerteinheit 4 kann in der in Figur 4 dargestellten Form beispielsweise in dem Digitalbaustein gemäß dem dritten Ausführungsbeispiel verwendet werden, wobei für die Auswerteeinheit soviel Eingangsleitungen 19 vorgesehen sein müssen, wie Testmusterausgaberegister 2 vorhanden sind. Weiterhin kann die in Figur 4 dargestellte Auswerteeinheit 4 auch in dem Digitalbaustein gemäß dem ersten Ausführungsbeispiel verwendet werden, wobei jeder Ausgang der Testeinheit 3 mit einer Eingangsleitung 19 der Auswerteeinheit 4 verbunden werden muss. Beim Betrieb der in Figur 4 dargestellten Auswerteeinheit muss sichergestellt sein, dass nach einer Änderung der an den Eingangsleitung 19 anliegenden Signale wenigstens ein Schiebetakt der Einzelregister 12 durchgeführt wird. Dies bedeutet, dass bei Verwendung der Auswerteeinheit 4 in einem Digitalbaustein gemäß dem dritten Ausführungsbeispiel aus Figur 3 bei jedem Schiebetakt der Testmusterausgaberegister 2 die Einzelregister 12 mindestens einen Takt weitergeschaltet werden. Bei Verwendung der Auswerteeinheit 4 in einem Digitalbeispiel gemäß dem ersten Ausführungsbeispiel müssen ebenfalls die Einzelregister 12 der Auswerteeinheit bei jedem Schiebetakt des Testmusterausgaberegisters 2 um mindestens einen Takt weitergeschaltet werden.

Durch die Rückkoppelung und die Exklusiv-Oder-Verknüpfungen bildet sich auf diese Weise abhängig vom Startzustand der Einzelregister 12 und den an den Eingangsleitungen 19 anliegenden Signalen eine Signatur, die charakteristisch für die an den Eingangsleitungen 19 anliegenden Signale ist. Zum Auslesen der auf diese Weise gebildeten Signatur muss das in Figur 4 dargestellte Schieberegister so umschaltbar sein, dass an einem bestimmten Zeitpunkt der Inhalt der Einzelregister 12 insbesondere seriell ausgelesen werden kann.

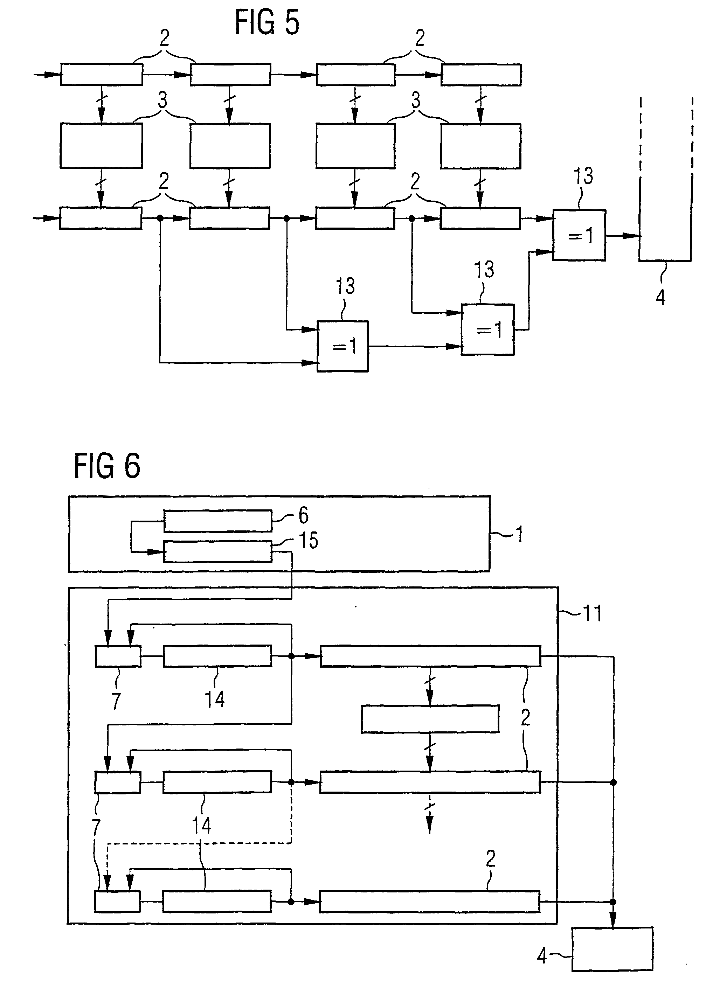

In Figur 5 ist ein Digitalbaustein gemäß einem vierten Ausführungsbeispiel der vorliegenden Erfindung teilweise dargestellt. Der wesentliche Unterschied zu den anderen Ausführungsformen besteht darin, dass die Testantworten schneller ausgewertet werden können. Wie in den vorangegangenen Ausführungsbeispielen werden Testeinheiten 3 mit Hilfe von Teilregistern 2 mit Testmustern beaufschlagt. Dabei sind die für vier Testeinheiten 3 vorgesehenen vier Teilregister 2 seriell miteinander verbunden, so dass sie ein einziges großes Schieberegister bilden. Die Ausgänge der vier Testeinheiten 3 beaufschlagen vier Teilregister 2, die derart eingerichtet sind, dass sie jeweils über einen parallelen Eingang die Testantwort einer Testeinheit 3 übernehmen können. Die miteinander verbundenen Teilregister 2 bilden in diesem Fall zusammen ein einziges Schieberegister. Die unten dargestellten Teilregister 2 weisen nicht dargestellte parallele Ausgänge zum Beaufschlagen weiterer Testeinheiten 3 auf. Weiterhin sind Exklusiv-Oder-Gatter 13 vorgesehen, die zusammen mit den Teilregistern 2 so verschaltet sind, dass der Ausgang jedes Teilregisters mit einem ersten Eingang eines Exklusiv-Oder-Gatters 13 verbunden ist, dessen zweiter Eingang mit dem Ausgang desjenigen Exklusiv-Oder-Gatters 13 verbunden ist, dessen erster Eingang vom Ausgang des vorangehenden Teilregisters 2 beaufschlagt wird. Am Ausgang des Exklusiv-Oder-Gatters 13, dessen erster Eingang vom in Schieberichtung des letzten Teilregisters 2 beaufschlagt wird, erscheint eine Bitfolge beim Hindurchschieben der Testantworten durch die Einzelregister 2, die gleichzeitig von den Inhalten aller vier Teilregister 2 beeinflusst wird. auf diese Weise ist es möglich, eine die Testantworten aus allen Einzelregistern 2 berücksichtigende Signatur zu erhalten, bereits wenn die Testantwort jedes kurzen Teilregisters 2 vollständig aus diesem Teilregister 2 herausgeschoben worden ist. Dies bietet sich insbesondere zum Auswerten von langen Testantworten an, in dem ein Register zur Aufnahme einer langen Testantwort in mehrere Einzelregister 2 aufgeteilt wird, an dessen Verbindungspunkten die zusätzliche Schaltung aus Exklusiv-Oder-Gattern angeschlossen wird. Am Ausgang des letzten Exklusiv-Oder-Gatters kann eine herkömmliche Auswerteeinheit 4, wie sie beispielsweise in Figur 4 beschrieben ist, angeschlossen werden, mit der auch gleichzeitig die Signale aus anderen Serienschaltungen von Einzelregistern 2 zuzüglich der zusätzlichen Exklusiv-Oder-Gatter ausgewertet bzw. komprimiert werden können.

In Figur 6 ist ein Digitalbaustein nach einem fünften Ausführungsbeispiel der vorliegenden Erfindung dargestellt. Die wesentlichen Merkmale befinden sich im Funktionselementblock 11, in dem mehrere Testmusterausgaberegister 2 vorgesehen sind, die auch zur Aufnahme von Testantworten dienen. Links von jedem Testmusterausgaberegister 2 ist ein Rückkoppelungsschieberegister 14 angeschlossen, wobei alle Rückkopplungschieberegister 14 mit Hilfe von Multiplexern 7 zusammen zu einem Schieberegister verschaltbar sind. Jeder Multiplexer 7 ist so eingerichtet, dass er den Eingang eines Rückkoppelungsschieberegisters 14 entweder mit dem Ausgang des rückgekoppelten Schieberegisters 14 oder mit dem Ausgang eines vorhergehenden Rückkoppelungsschieberegisters 14 verbinden kann. Beim ersten Rückkoppelungsschieberegister 14 kann der Multiplexer 7 den Eingang entweder mit dem Ausgang des Rückkoppelungsschieberegisters 14 oder mit einem Submusterausgang der Selbsttesteinheit 1 verbinden. Mit Hilfe dieser Ausgestaltung ist es möglich, innerhalb des Funktionselementblocks 11 die Testmuster ausgehend von Submustern zu erzeugen. Dabei ist es auf Grund der mehrfach vorhandenen Rückkoppelungsschieberegister 14 auch möglich, gleichzeitig ausgehend von unterschiedlichen Submustern unterschiedliche Testmuster zu erzeugen. Dies bietet sich beispielsweise in den Fällen an, in denen auf Grund von unterschiedlichen Testeinheiten 3 die Testmusterausgaberegister 2 vorteilhafterweise mit unterschiedlichen Testmustern geladen werden. Die Selbsttesteinheit 1 umfasst ein Submusterschieberegister 15 und einen Speicher 6 zur Aufnahme einer Reihe von Submustern. Das Submusterschieberegister 15 überträgt ein Submuster seriell in den Funktionselementblock 11.

Die Ausgänge der Testmusterausgaberegister 2 sind mit Eingängen einer Auswerteeinheit 4 verbunden, um wie zuvor bereits beschrieben zur Auswertung der Testantworten eine Signatur aller seriell aus den Testmusterausgaberegistern 2 herausgeschobenen Testantworten zu erzeugen.

Zum Laden der Testmusterausgaberegister 2 werden zunächst die Multiplexer 7 so angesteuert, dass sie die Eingänge der Rückkoppelungsschieberegister 14 mit dem Eingang des jeweils vorhergehenden Rückkopplungsschieberegister 14 bzw. dem Submusterschieberegister 15 verbinden. Dieser Phase wird eine Submuster aus dem Speicher 6 mit Hilfe des Submusterschieberegisters 15 durch den ersten Multiplexer 7 in das erste Rückkopplungsschieberegister 14 geladen. Danach kann wiederholt entweder das gleiche Submuster oder ein anderes Submuster hinterhergeschoben werden mit der Folge, dass am Ende alle Rückkopplungsschieberegister 14 mit einem Submuster gefüllt sind, wobei die Rückkopplungsschieberegister 14 abhängig von den vom Submusterschieberegister 15 herausgeschobenen Submuster mit beliebigen und verschiedenen Submustern gefüllt sein können. Wenn die Rückkopplungsschieberegister 14 mit den gewünschten Submustern geladen sind, werden die Multiplexer 7 so angesteuert, dass sie die Eingänge der Rückkopplungsschieberegister 14 mit den Ausgängen verbinden, so dass sie im rückgekoppelten Betrieb arbeiten und auf diese Weise das in ihnen geladene Submuster periodisch wiederholen und in das entsprechende Testmusterausgaberegister 2 laden. Die Selbsttesteinheit 1 kann dabei noch zahlreiche andere nicht dargestellte Komponenten, die zur Durchführung des Selbsttests des Digitalbausteins erforderlich sind und im Zusammenhang mit anderen Ausführungsformen beschrieben sind, enthalten.

## Patentansprüche

1. Digitalbaustein mit Funktionselementen, die wenigstens einer Testeinheit (3) mit Eingängen und Ausgängen zugeordnet sind, wenigstens einem Testmusterausgaberegister (2) mit einem parallelen Ausgang zum Beaufschlagen der Eingänge der wenigstens einen Testeinheit (3) mit einem Testmuster, und einer Selbsttesteinheit (1) zum Steuern des Testmusterausgaberegisters (2) und zum Laden des Testmusterausgaberegisters (2) mit einem Testmuster, das die Form eines Digitalwerts aufweist,
**dadurch gekennzeichnet,**
**dass** die Selbsttesteinheit (1) derart ausgestaltet ist, dass sie das Testmuster als eine periodische Folge eines Submusters erzeugt, das ebenfalls die Form eines Digitalwerts aufweist,
wobei eine maximale Periodizität des Testmusters in Abhängigkeit wenigstens einer Wirkanzahl von Eingängen der Testeinheit (3) für einen bestimmten Ausgang der Testeinheit (3) bestimmt wird, wobei die Wirkanzahl die Anzahl von Eingängen der Testeinheit (3) ist, an denen sich allein Änderungen auf den bestimmten Ausgang der Testeinheit (3) auswirken.

2. Digitalbaustein nach Anspruch 1,
**dadurch gekennzeichnet,**
**dass** der Digitalbaustein wenigstens eine Auswerteeinheit (4) zum Auswerten einer an den Ausgängen der wenigstens einen Testeinheit (3) anliegenden Testmusterantwort aufweist.

3. Digitalbaustein nach Anspruch 2,
**dadurch gekennzeichnet,**
**dass** der Digitalbaustein wenigstens ein Testantwortleseregister aufweist, das mit den Ausgängen der Testeinheit (3) verbunden ist und derart eingerichtet ist, dass es zumindest in einem Testmodus des Digitalbausteins eine an den Ausgängen der Testeinheit (3) anliegende Testantwort übernehmen und seriell zu der Auswerteeinheit (4) weitergeben kann.

4. Digitalbaustein nach Anspruch 3,
**dadurch gekennzeichnet,**
**dass** der Digitalbaustein Funktionselemente aufweist, die Register sind und derart eingerichtet sind, dass sie von der Selbsttesteinheit (1) zu dem wenigstens einen Testantwortleseregister (2) umgeschaltet werden können.

5. Digitalbaustein nach Anspruch 3 oder 4,
**dadurch gekennzeichnet,**
**dass** die Selbsttesteinheit (1) derart eingerichtet ist, dass sie die Testmusterausgaberegister (2) vollständig mit einem neuen Testmuster laden und anschließend die Testantwortleseregister derart ansteuern kann, dass sie die Testantwort übernehmen.

6. Digitalbaustein nach einem der Ansprüche 3 bis 5,
**dadurch gekennzeichnet,**
**dass** das Testantwortleseregister von einem Testmusterausgaberegister (2) gebildet ist, das Eingänge aufweist, die mit Ausgängen einer Testeinheit (3) verbunden sind.

7. Digitalbaustein nach einem der Ansprüche 3 bis 6,
**dadurch gekennzeichnet,**
**dass** das Testantwortleseregister ein in Einzelschieberegister (12) unterteiltes Schieberegister ist und derart eingerichtet ist, dass es an die Auswerteeinheit (4) das Ergebnis einer Exklusiv-Oder-Verknüpfung zwischen einem Ausgangssignal des in Schieberichtung des Schieberegisters letzten Einzelschieberegisters (12) und einem Ausgangssignal wenigstens eines weiteren Einzelschieberegisters (12) seriell weitergeben kann.

8. Digitalbaustein nach einem der Ansprüche 2 bis 7,
**dadurch gekennzeichnet,**
**dass** die Auswerteeinheit (4) ein rückgekoppeltes Schieberegister aus mehreren Einzelregistern (12) ist, dessen Eingang mit dem Ergebnis einer ersten Exklusiv-Oder-Verknüpfung zwischen dem Ausgang des in Schieberichtung des Schieberegisters letzten Einzelregister (12) und dem Ausgang wenigstens eines weiteren Einzelregisters (12) beaufschlagt werden kann, wobei der Eingang wenigstens eines Einzelregisters (12) mit dem Ergebnis wenigstens einer zweiten Exklusiv-Oder-Verknüpfung zwischen dem Ergebnis der ersten Exklusiv-Oder-Verknüpfung oder dem Ausgang des vorangehenden Einzelregisters (12) und einem Ausgangssignal der wenigstens einen Testeinheit (3) beaufschlagbar ist, wobei im Falle des in Schieberichtung ersten Einzelregisters (12) der Eingang mit dem Ergebnis einer weiteren Exklusiv-Oder-Verknüpfung zwischen dem Ergebnis der ersten Exklusiv-Oder-Verknüpfung und einem Ausgangssignal der wenigstens einen Testeinheit (3) beaufschlagbar ist.

9. Digitalbaustein nach einem der vorhergehenden Ansprüche,
**dadurch gekennzeichnet,**
**dass** das Testmusterausgaberegister (2) ein Schieberegister ist, das derart eingerichtet ist, dass das Testmuster von der Selbsttesteinheit (1) seriell in das Testmusterausgaberegister (2) geladen werden kann.

10. Digitalbaustein nach einem der vorhergehenden Ansprüche,
**dadurch gekennzeichnet,**
**dass** der Digitalbaustein Funktionselemente aufweist, die Register sind und derart eingerichtet sind, dass sie von der Selbsttesteinheit (1) zu dem wenigstens einen Testmusterausgaberegister (2) umgeschaltet werden können.

11. Digitalbaustein nach einem der vorhergehenden Ansprüche,
**dadurch gekennzeichnet,**
**dass** die Selbsttesteinheit (1) einen Speicher (6) aufweist und derart eingerichtet ist, dass sie das Testmuster mittels eines im Speicher (6) abgelegten Submusters als periodische Folge des Submusters mit variabler Periodizität bilden kann.

12. Digitalbaustein nach einem der vorhergehenden Ansprüche,
**dadurch gekennzeichnet,**
**dass** die Selbsttesteinheit (1) einen Zähler aufweist und derart eingerichtet ist, dass sie den Zähler in Aufwärts- und/oder Abwärts-Zählrichtung betreiben kann und das Testmuster mittels des Zählerstands des Zählers als Submuster bilden kann.

13. Digitalbaustein nach einem der vorhergehenden Ansprüche,
**dadurch gekennzeichnet,**
**dass** der Digitalbaustein mehrere Testmusterausgaberegister (2) aufweist und derart eingerichtet ist, dass die Testmusterausgaberegister (2) gleichzeitig mit dem gleichen Testmuster geladen werden.

14. Digitalbaustein nach einem der vorhergehenden Ansprüche,
**dadurch gekennzeichnet,**
**dass** der Digitalbaustein wenigstens ein rückgekoppeltes Submusterschieberegister (14) aufweist, das mit einem Submuster ladbar ist und derart eingerichtet ist, dass es seriell das Testmuster als periodische Folge des Submusters ausgeben kann.

15. Digitalbaustein nach Anspruch 14,
**dadurch gekennzeichnet,**
**dass** das Submusterschieberegister (14) derart eingerichtet ist, dass es das Testmuster als periodische Folge des Submusters mit variabler Periodizität ausgeben kann.

16. Digitalbaustein nach Anspruch 14 oder 15,
**dadurch gekennzeichnet,**
**dass** das Submusterschieberegister (14) in der Selbsttesteinheit (1) enthalten ist.

17. Digitalbaustein nach Anspruch 14 oder 15,
**dadurch gekennzeichnet,**
**dass** die Register des Testmusterausgaberegisters (2) wenigstens teilweise zu dem Submusterschieberegister (14) umschaltbar sind.

18. Digitalbaustein nach Anspruch 14 oder 15,
**dadurch gekennzeichnet,**
**dass** ein Teil des Testmusterausgaberegisters (2) das Submusterschieberegister (14) bildet.

19. Digitalbaustein nach einem der vorhergehenden Ansprüche,
**dadurch gekennzeichnet,**
**dass** das Testmusterausgaberegister (2) derart mit der Testeinheit (3) verschaltet ist, dass die Eingänge der Testeinheit (3), an denen sich allein Änderungen auf einen bestimmten Ausgang der Testeinheit (3) auswirken, in Bezug auf die Reihenfolge der Ausgänge des Testmusterausgaberegisters (2) möglichst nahe beisammen liegen.

20. Digitalbaustein nach einem der vorhergehenden Ansprüche,
**dadurch gekennzeichnet,**
**dass** die Testeinheit (3) derart eingerichtet ist, dass die Wirkanzahlen von Eingängen der Testeinheit (3) für die Ausgänge der Testeinheit (3) möglichst klein sind.

21. Digitalbaustein nach einem der vorhergehenden Ansprüche,
**dadurch gekennzeichnet,**
**dass** der Digitalbaustein nach außen geführte Steuerleitungen für die Selbsttesteinheit (1) aufweist, wobei die Selbsttesteinheit (1) derart eingerichtet ist, dass sie anhand von über die Steuerleitungen eingebbaren Befehlen steuerbar ist.

22. Digitalbaustein mit Funktionselementen, die wenigstens einer Testeinheit (3) mit Eingängen und Ausgängen zugeordnet sind, wenigstens einem Testmusterausgaberegister (2) mit einem parallelen Ausgang zum Beaufschlagen der Eingänge der wenigstens einen Testeinheit (3) mit einem Testmuster, wenigstens einer Auswerteeinheit (4) zum Auswerten einer an den Ausgängen der wenigstens einen Testeinheit (3) anliegenden Testmusterantwort und einer Selbsttesteinheit (1) zum Steuern des wenigstens einen Testmusterausgaberegisters (2) und der Auswerteeinheit (4) und zum Laden des Testmusterausgaberegisters mit dem Testmuster, das die Form eines Binärwerts aufweist,
**dadurch gekennzeichnet,**
**dass** die Selbsttesteinheit (1) derart ausgestaltet ist, dass sie das Testmuster als Folge wenigstens eines aus einer Liste von Submustern auswählbaren Submusters erzeugt, wobei das Testmusterausgaberegister (2) ein Schieberegister ist, das seriell mit dem Testmuster geladen werden kann, und die Auswerteeinheit (4) derart eingerichtet ist, dass es bei jedem Takt, mit dem ein neuer Teil des Testmusters in das Testmusterausgaberegister (2) geladen wird, die Testmusterantwort auswerten kann,
wobei die maximale Länge der Submuster in Abhängigkeit wenigstens einer Wirkanzahl von Eingängen einer Testeinheit (3) für einen bestimmten Ausgang der Testeinheit (3) ist, wobei die Wirkanzahl die Anzahl von Eingängen der Testeinheit (3) ist, an denen sich allein Änderungen auf den bestimmten Ausgang der Testeinheit (3) auswirken.

23. Digitalbaustein nach Anspruch 22,
**dadurch gekennzeichnet,**
**dass** die Auswerteeinheit (4) ein rückgekoppeltes Schieberegister aus mehreren Einzelregistern (12) ist, dessen Eingang mit dem Ergebnis einer ersten Exklusiv-Oder-Verknüpfung zwischen dem Ausgang des in Schieberichtung des Schieberegisters letzten Einzelregisters (12) und dem Ausgang wenigstens eines weiteren Einzelregisters (12) des Schieberegisters beaufschlagt ist.

24. Digitalbaustein nach Anspruch 22 oder 23,
**dadurch gekennzeichnet,**
**dass** der Digitalbaustein Funktionselemente aufweist, die Register sind und derart eingerichtet sind, dass sie von der Selbsttesteinheit (1) zu dem wenigstens einen Testmusterausgaberegister (2) umgeschaltet werden können.

25. Digitalbaustein nach einem der Ansprüche 22 bis 24,
**dadurch gekennzeichnet,**
**dass** die Selbsttesteinheit (1) einen Speicher (6) aufweist, und derart eingerichtet ist, dass sie das Testmuster mittels im Speicher (6) abgelegter Submuster bilden kann.

26. Digitalbaustein nach einem der Ansprüche 22 bis 25,
**dadurch gekennzeichnet,**
**dass** die Selbsttesteinheit (1) einen Zähler aufweist und derart eingerichtet ist, dass sie den Zähler in Auf- und/oder Abwärts-Zählrichtung betreiben kann und das Testmuster mittels der Zählerstände des Zählers bilden kann.

27. Digitalbaustein nach einem der Ansprüche 22 bis 26,
**dadurch gekennzeichnet,**
**dass** der Digitalbaustein mehrere Testmusterausgaberegister (2) aufweist und derart eingerichtet ist, dass die Testmusterausgaberegister (2) gleichzeitig mit dem gleichen Testmuster geladen werden.

28. Verfahren zum Testen eines Digitalbausteins, wobei der Digitalbaustein Funktionselemente, die wenigstens einer Testeinheit (3) mit Eingängen und Ausgängen zugeordnet sind, wenigstens ein Testmusterausgaberegister (2) mit einem parallelen Ausgang zum Beaufschlagen der Eingänge der wenigstens einen Testeinheit (3) mit einem Testmuster und eine Selbsttesteinheit (1) zum Steuern des Testmusterausgaberegisters (2) und zum Laden des Testmusterausgaberegisters (2) mit einem Testmuster, das die Form eines Digitalwerts aufweist, aufweist,
**dadurch gekennzeichnet,**
**dass** das Testmuster als periodische Folge eines Submusters erzeugt wird, das ebenfalls die Form eines Digitalwerts aufweist,
**dass** das wenigstens eine Testmusterregister (2) mit einem Testmuster geladen wird, und dass das Antwortverhalten der wenigstens einen Testeinheit (3) auf das Testmuster ausgewertet wird,
wobei eine maximale Periodizität des Testmusters in Abhängigkeit wenigstens einer Wirkanzahl von Eingängen der Testeinheit (3) für einen bestimmten Ausgang der Testeinheit (3) bestimmt wird, wobei die Wirkanzahl die Anzahl von Eingängen der Testeinheit (3) ist, an denen sich allein Änderungen auf den bestimmten Ausgang der Testeinheit (3) auswirken.

29. Verfahren zum Testen eines Digitalbausteins, wobei der Digitalbaustein Funktionselemente, die wenigstens einer Testeinheit (3) mit Eingängen und Ausgängen zugeordnet sind, und wenigstens ein Testmusterausgaberegister (2) mit einem parallelen Ausgang zum Beaufschlagen der Eingänge der wenigstens einen Testeinheit (3) mit einem Testmuster, das die Form eines Digitalwerts aufweist, wobei das Testmusterausgaberegister (2) als Schieberegister ausgebildet ist, aufweist,
**dadurch gekennzeichnet,**
**dass** das Testmusterausgaberegister (2) mit dem Testmuster seriell geladen wird und mit jedem Takt, mit dem ein Bit des Testmusters in das Testmusterausgaberegister (2) geladen wird, eine an den Ausgängen der wenigstens einen Testeinheit (3) anliegenden Testmusterantwort ausgewertet wird, wobei das Testmuster als eine Folge wenigstens eines aus einer Liste von Submustern auswählbaren Submusters erzeugt wird, wobei die maximale Länge der Submuster in Abhängigkeit wenigstens einer Wirkanzahl von Eingängen einer Testeinheit (3) für einen bestimmten Ausgang der Testeinheit (3) ist, wobei die Wirkanzahl die Anzahl von Eingängen der Testeinheit (3) ist, an denen sich allein Änderungen auf den bestimmten Ausgang der Testeinheit (3) auswirken.

30. Verfahren nach Anspruch 28 oder 29,
**dadurch gekennzeichnet,**
**dass** zur Auswertung einer Testmusterantwort bei einem rückgekoppelten Schieberegister mit mehreren Einzelregistern (12), dessen Eingang mit dem Ergebnis einer ersten Exklusiv-Oder-Verknüpfung zwischen dem Ausgang des in Schieberichtung letzten Einzelregisters (12) und dem Ausgang wenigstens eines weiteren Einzelregisters (12) des Schieberegisters beaufschlagt wird, wobei der Eingang wenigstens eines Einzelregisters (12) mit dem Ergebnis wenigstens einer zweiten Exklusiv-Oder-Verknüpfung zwischen dem Ergebnis der ersten Exklusiv-Oder-Verknüpfung oder dem Ausgang des vorangehenden Einzelregisters (12) und einem Ausgangssignal der Testeinheit (3) beaufschlagt wird, wobei im Falle des in Schieberichtung ersten Einzelregisters (12) der Eingang mit dem Ergebnis einer weiteren Exklusiv-Oder-Verknüpfung zwischen dem Ergebnis der ersten Exklusiv-Oder-Verknüpfung und einem Ausgangssignal der Testeinheit (3) beaufschlagt wird, so dass in dem rückgekoppelten Schieberegister in Abhängigkeit des wenigstens einen Ausgangs der Testeinheit (3) eine Signatur gebildet wird.

31. Verfahren nach Anspruch 28 oder 29,
**dadurch gekennzeichnet,**
**dass** eine an den Ausgängen der wenigstens einen Testeinheit (3) anliegende Testmusterantwort mit Hilfe von wenigstens einem Testmusterleseregister zu einem bestimmten Zeitpunkt übernommen wird und seriell zur Auswertung an eine Auswerteeinheit (4) weitergegeben wird.

32. Verfahren nach Anspruch 31,
**dadurch gekennzeichnet,**
**dass** das Testmusterleseregister (2) von einem Testmusterausgaberegister (2) gebildet wird, wobei bei der Übernahme der Testmusterantwort in ein Testmusterantwortleseregister der Inhalt des Testmusterausgaberegisters (2) überschrieben wird.

33. Verfahren nach Anspruch 32,
**dadurch gekennzeichnet,**
**dass** jedes Testmusterausgaberegister (2) des Digitalbausteins sowohl zum Beaufschlagen der Eingänge der wenigstens einen Testeinheit (3) mit einem Testmuster als auch als Testmusterantwortleseregister dient.

34. Verfahren nach Anspruch 29 oder 30 und einem der Ansprüche 31 bis 33,
**dadurch gekennzeichnet,**
**dass** die Testmusterantwort der Testeinheit (3) mittels des Testmusterleseregisters (2) seriell zur Signaturbildung an das rückgekoppelte Schieberegister zur Auswertung weitergegeben wird, wobei der serielle Ausgabetakt des Testmusterleseregisters (2) gleich dem seriellen Schiebetakt des rückgekoppelten Schieberegisters zur Auswertung ist.

35. Verfahren nach Anspruch 28 oder 29,
**dadurch gekennzeichnet,**
**dass** das Testmusterantwortverhalten der wenigstens einen Testeinheit (3) durch electron-beam-Testverfahren ausgewertet wird.

36. Vorrichtung zum Testen eines Digitalbausteins, wobei der Digitalbaustein Funktionselemente, die wenigstens einer Testeinheit (3) mit Eingängen und Ausgängen zugeordnet sind, wenigstens ein Testmusterausgaberegister (2) mit einem parallelen Ausgang zum Beaufschlagen der Eingänge der wenigstens einen Testeinheit (3) mit einem Testmuster, wenigstens einer aus Lese- oder Auswerteeinheit zum Auslesen bzw. zum Auswerten einer an den Ausgängen der wenigstens einen Testeinheit (3) anliegenden Testmusterantwort, und einer Selbsttesteinheit (1) zum Steuern des Testmusterausgaberegisters (2) und der Auswerte- bzw. Ausleseeinheit und zum Laden des Testmusterausgaberegisters (2) mit wenigstens einem Testmuster, das die Form eines Digitalwerts aufweist,
wobei die Vorrichtung eine Datenverarbeitungseinrichtung zum Erzeugen von Testdaten, und eine Testmusterübertragungseinheit aufweist, die derart eingerichtet ist, dass sie Testmuster in den Digitalbaustein zum Laden in das wenigstens eine Testmusterausgaberegister (2) übertragen kann,
**dadurch gekennzeichnet,**
**dass** das Testmuster eine Folge wenigstens eines Submusters ist, welches aus einer Liste von Submustern auswählbar ist, oder eine periodische Folge eines Submusters ist, wobei das Submuster ebenfalls die Form eines Digitalwerts aufweist, und die Vorrichtung so eingerichtet ist, dass die Datenverarbeitungseinrichtung als Testmusterdaten das wenigstens eine Submuster erzeugt und zur Testmusterübertragungseinheit überträgt und die Testmusterübertragungseinheit aus dem von der Datenverarbeitungseinheit empfangenen wenigstens einen Submuster das Testmuster zum Laden in den Digitalbaustein erzeugt,
wobei eine maximale Periodizität des Testmusters bzw. eine maximale Länge der Submuster in Abhängigkeit wenigstens einer Wirkanzahl von Eingängen der Testeinheit (3) für einen bestimmten Ausgang der Testeinheit (3) bestimmt wird, wobei die Wirkanzahl die Anzahl von Eingängen der Testeinheit (3) ist, an denen sich allein Änderungen auf einen bestimmten Ausgang der Testeinheit (3) auswirken.

37. Vorrichtung nach Anspruch 36,
**dadurch gekennzeichnet,**
**dass** die Testmusterübertragungseinheit eine Nadelplatte mit Kontaktierungsspitzen zum Kontaktieren von Kontaktpunkten auf dem Digitalbaustein ist.

38. Vorrichtung zum Testen eines Digitalbausteins nach Ansprüch 36,
**dadurch gekennzeichnet,**
**dass** die Vorrichtung derart eingerichtet ist, dass sie über aus dem Digitalbaustein herausführende Steuerleitungen an die Selbsttesteinheit (1) innerhalb des Digitalbausteins Steuerbefehle zum Erzeugen des wenigstens einen Submusters oder Steuerbefehle zum Auswählen des wenigstens einen Submusters aus gespeicherten Submustern oder das wenigstens eine Submuster jeweils zur Erzeugung von Testmustern innerhalb des Digitalbausteins übertragen kann.

## Claims

1. Digital module with functional elements, which are assigned to at least one test unit (3) with inputs and outputs, at least one test-pattern output register (2) with a parallel output for applying a test pattern to the inputs of the at least one test unit (3), and a self-test unit (1) for controlling the test-pattern output register (2) and for loading the test-pattern output register (2) with a test pattern which is in the form of a digital value,
**characterised in that**
the self-test unit (1) is configured so that it generates the test pattern as a periodic sequence of a sub-pattern, which is also in the form of a digital value,
a maximum periodicity of the test pattern being determined as a function of at least one active number of inputs of the test unit (3) for a particular output of the test unit (3), the active number being the number of inputs of the test unit (3) where, and only where, changes affect the particular output of the test unit (3).

2. Digital module according to Claim 1,
**characterised in that**
the digital module has at least one evaluation unit (4) for evaluating a test-pattern response applied to the outputs of the at least one test unit (3).

3. Digital module according to Claim 2,
**characterised in that**
the digital module has at least one test-response read register, which is connected to the outputs of the test unit (3) and is designed so that, at least in a test mode of the digital module, it can accept a test response applied to the outputs of the test unit (3) and forward it serially to the evaluation unit (4).

4. Digital module according to Claim 3,
**characterised in that**
the digital module has functional elements which are registers, and which are designed so that they can be switched over from the self-test unit (1) to the at least one test-response read register (2).

5. Digital module according to Claim 3 or 4,
**characterised in that**
the self-test unit (1) is designed so that it can load the test-pattern output registers (2) completely with a new test pattern and subsequently drive the test-response read registers so that they accept the test response.

6. Digital module according to any one of Claims 3 to 5,
**characterised in that**
the test-response read register is formed by a test-pattern output register (2), which has inputs connected to outputs of a test unit (3).

7. Digital module according to any one of Claims 3 to 6,
**characterised in that**
the test-response read register is a shift register subdivided into individual shift registers (12), and is designed so that it can serially forward the result of an exclusive-OR operation, between an output signal of the last individual shift register (12) in the shift direction of the shift register and an output signal of at least one other individual shift register (12), to the evaluation unit (4).

8. Digital module according to any one of Claims 2 to 7,
**characterised in that**
the evaluation unit (4) is a feedback shift register which comprises a plurality of individual registers (12) and the input of which can receive the result of a first exclusive-OR operation, between the output of the last individual register (12) in the shift direction of the shift register and the output of at least one other individual register (12), the output of at least one individual register (12) being able to receive the result of at least one second exclusive-OR operation, between the result of the first exclusive-OR operation or the output of the previous individual register (12) and an output signal of a test unit (3), and the input in the case of the first individual register (12) in the shift direction being able to receive the result of another exclusive-OR operation, between the result of the first exclusive-OR operation and an output signal of a test unit (3).

9. Digital module according to any one of the preceding claims,
**characterised in that**
the test-pattern output register (2) is a shift register, which is designed so that the test pattern can be loaded serially into the test-pattern output register (2) from the self-test unit (1).

10. Digital module according to any one of the preceding claims,
**characterised in that**
the digital module has functional elements which are registers, and which are designed so that they can be switched over from the self-test unit (1) to the at least one test-pattern output register (2).

11. Digital module according to any one of the preceding claims,
**characterised in that**
the self-test unit (1) has a memory (6) and is designed so that it can form the test pattern by means of a sub-pattern stored in the memory (6), as a periodic sequence of the sub-pattern with a variable periodicity.

12. Digital module according to any one of the preceding claims,
**characterised in that**
the self-test unit (1) has a counter and is designed so that it can operate the counter in the upwards and/or downwards counting direction and form the test pattern as a sub-pattern by means of the counter state of the counter.

13. Digital module according to any one of the preceding claims,
**characterised in that**
the digital module has a plurality of test-pattern output registers (2) and is designed so that the test-pattern output registers (2) are loaded simultaneously with the same test pattern.

14. Digital module according to any one of the preceding claims,
**characterised in that**
the digital module has at least one feedback sub-pattern shift register (14), which can be loaded with a sub-pattern and is designed so that it can output the test-pattern serially as a periodic sequence of the sub-pattern.

15. Digital module according to Claim 14,
**characterised in that**
the sub-pattern shift register (14) is designed so that it can output the test pattern as a periodic sequence of the sub-pattern with a variable periodicity.

16. Digital module according to Claim 14 or 15,
**characterised in that**
the sub-pattern shift register (14) is contained in the self-test unit (1).

17. Digital module according to Claim 14 or 15,
**characterised in that**
at least some of the registers of the sub-pattern output register (2) can be switched over to the sub-pattern shift register (14).

18. Digital module according to Claim 14 or 15,
**characterised in that**
some of the test-pattern output register (2) forms the sub-pattern shift register (14).

19. Digital module according to any one of the preceding claims,
**characterised in that**
the test-pattern output register (2) is interconnected with the test unit (3) so that the outputs of the test unit (3) where, and only where, changes affect the particular output of the test unit (3), are as close together as possible with respect to the order of the outputs of the test-pattern output register (2).

20. Digital module according to any one of the preceding claims,
**characterised in that**
the test unit (3) is designed so that the active numbers of inputs of the test unit (3) for the outputs of the test unit (3) are as small as possible.

21. Digital module according to any one of the preceding claims,
**characterised in that**
the digital module has outgoing control lines for the self-test unit (1), the self-test unit (1) being designed so that it can be controlled with the aid of instructions that can be input via the control lines.

22. Digital module with functional elements which are assigned to at least one test unit (3) with inputs and outputs, at least one test-pattern output register (2) with a parallel output for applying a test pattern to the inputs of the at least one test unit (3), at least one evaluation unit (4) for evaluating a test-pattern response applied to the outputs of the at least one test unit (3) and a self-test unit (1) for controlling the at least one test-pattern output register (2) and the evaluation unit (4) and for loading the test-pattern output register with the test pattern, which is in the form of a binary value,
**characterised in that**
the self-test unit (1) is configured so that it generates the test pattern as a sequence of at least one sub-pattern, which can be selected from a list of sub-patterns, the test-pattern output register (2) being a shift register which can be loaded serially with the test pattern, and the evaluation unit (4) is designed so that it can evaluate the test-pattern response at each cycle with which a new part of the test pattern is loaded into the test-pattern output register (2),
the maximum length of the sub-pattern being a function of at least one active number of inputs of a test unit (3) for a particular output of the test unit (3), the active number being the number of inputs of the test unit (3) where, and only where, changes affect the particular output of the test unit (3).

23. Digital module according to Claim 22,
**characterised in that**
the evaluation unit (4) is a feedback shift register which comprises a plurality of individual registers (12) and the input of which receives the result of a first exclusive-OR operation, between the output of the last individual register (12) in the shift direction of the shift register and the output of at least one other individual register (12) of the shift register.

24. Digital module according to Claim 22 or 23,
**characterised in that**
the digital module has functional elements which are registers, and which are designed so that they can be switched over from the self-test unit (1) to the at least one test-response read register (2).

25. Digital module according to any one of Claims 22 to 24,
**characterised in that** the
the self-test unit (1) has a memory (6) and is designed so that it can form the test pattern by means of sub-patterns stored in the memory (6).

26. Digital module according to any one of Claims 22 to 25,
**characterised in that**
the self-test unit (1) has a counter and is designed so that it can operate the counter in the upwards and/or downwards counting direction and form the test pattern by means of the counter states of the counter.

27. Digital module according to any one of Claims 22 to 26,
**characterised in that**
the digital module has a plurality of test-pattern output registers (2) and is designed so that the test-pattern output registers (2) are loaded simultaneously with the same test pattern.

28. Method for testing a digital module, the digital module having functional elements which are assigned to at least one test unit (3) with inputs and outputs, at least one test-pattern output register (2) with a parallel output for applying a test pattern to the inputs of the at least one test unit (3), and a self-test unit (1) for controlling the test-pattern output register (2) and for loading the test-pattern output register (2) with a test pattern which is in the form of a digital value,
**characterised in that**
the test pattern is generated as a periodic sequence of a sub-pattern, which is also in the form of a digital value, **in that** the at least one test-pattern register (2) is loaded with a test pattern, and **in that** the response behaviour of the at least one test unit (3) to the test pattern is evaluated,
a maximum periodicity of the test pattern being determined as a function of at least one active number of inputs of the test unit (3) for a particular output of the test unit (3), the active number being the number of inputs of the test unit (3) where, and only where, changes affect the particular output of the test unit (3).

29. Method for testing a digital module, the digital module having functional elements which are assigned to at least one test unit (3) with inputs and outputs, and at least one test-pattern output register (2) with a parallel output for applying a test pattern which is in the form of a digital value to the inputs of the at least one test unit (3), the test-pattern output register (2) being designed as a shift register,
**characterised in that**
the test-pattern output register (2) is loaded serially with the test pattern and a test-pattern response applied to the outputs of the at least one test unit (3) is evaluated at each cycle with which a bit of the test pattern is loaded into the test-pattern output register (2), the test pattern being generated as a sequence of at least one sub-pattern which can be selected from a list of sub-patterns, the maximum length of the sub-pattern being a function of at least one active number of inputs of a test unit (3) for a particular output of the test unit (3), the active number being the number of inputs of the test unit (3) where, and only where, changes affect the particular output of the test unit (3).

30. Method according to Claim 28 or 29,
**characterised in that**
in order to evaluate a test-pattern response in a feedback shift register, which has a plurality of individual registers (12) and the input of which receives the result of a first exclusive-OR operation, between the output of the last individual register (12) in the shift direction and the output of at least one other individual register (12) of the shift register, the input of at least one individual shift register (12) is supplied with the result of at least one second exclusive-OR operation, between the result of the first exclusive-OR operation or the output of the previous individual register (12) and an output signal of a test unit (3), and the input in the case of the first individual register (12) in the shift direction receiving the result of another exclusive-OR operation, between the result of the first exclusive-OR operation and an output signal of a test unit (3), so that a signature is formed in the feedback shift register as a function of the at least one output of the test unit (3).

31. Method according to Claim 28 or 29,
**characterised in that**
a test-pattern response applied to the outputs of the at least one test unit (3) is accepted with the aid of at least one test-pattern read register at a particular time and forwarded serially to an evaluation unit (4) for evaluation.

32. Method according to Claim 31,
**characterised in that**,
the test-pattern read register (2) is formed by a test-pattern output register (2), the content of the test-pattern output register (2) being overwritten when the test-pattern response is accepted into a test-pattern response read register.

33. Method according to Claim 32,
**characterised in that**,
each test-pattern output register (2) of the digital module is used both for applying a test pattern to the inputs of the at least one test unit (3) and as a test-pattern response read register.

34. Method according to Claim 29 or 30 and one of Claims 31 to 33,
**characterised in that**
the test-pattern response of the test unit (3) is forwarded by means of the test-pattern read register (2) serially to the feedback shift register for signature formation, the serial output cycling rate of the test-pattern read register (2) being the same as the serial shift cycling rate of the feedback shift register for the evaluation.

35. Method according to Claim 28 or 29,
**characterised in that**
the test-pattern response behaviour of the at least one test unit (3) is evaluated by electron-beam test methods.

36. Device for testing a digital module, the digital module having functional elements which are assigned to at least one test unit (3) with inputs and outputs, at least one test-pattern output register (2) with a parallel output for applying a test pattern to the inputs of the at least one test unit (3), at least one of a read or evaluation unit, respectively for reading or evaluating a test-pattern response applied to the outputs of the at least one test unit (3), and a self-test unit (1) for controlling the test-pattern output register (2) and the evaluation or read unit and for loading the test-pattern output register (2) with at least one test pattern, which is in the form of a digital value,
the device having a data processing instrument for generating test data, and a test-pattern transfer unit which is designed so that it can transfer test patterns into the digital module for loading into the at least one test-pattern output register (2),
**characterised in that**
the test pattern is a sequence of at least one sub-pattern, which can be selected from a list of sub-patterns, or a periodic sequence of a sub-pattern, the sub-pattern also being in the form of a digital value, and the device being designed so that the data processing instrument generates the at least one sub-pattern as test-pattern data and transfers it to the test-pattern transfer unit, and the test-pattern transfer unit generates the test pattern for loading into the digital module from the at least one sub-pattern received from the data-processing unit,
a maximum periodicity of the test-pattern or a maximum length of the sub-pattern being determined as a function of at least one active number of inputs of the test unit (3) for a particular output of the test unit (3), the active number being the number of inputs of the test unit (3) where, and only where, changes affect the particular output of the test unit (3).

37. Device according to Claim 36,
**characterised in that**
the test-pattern transfer unit is a needle plate with contacting pins for contacting contact points on the digital module.

38. Device for testing a digital module according to Claim 36,
**characterised in that**
the device is designed so that it can transfer control instructions for generating the at least one sub-pattern, or control instructions for selecting the at least one sub-pattern from stored sub-patterns, or the at least one sub-pattern to a self-test unit (1) inside the digital module via outgoing control lines from the digital module, in each case in order to generate test patterns inside the digital module.

## Revendications

1. Module numérique comprenant des éléments fonctionnels, qui sont associés à au moins une unité de test (3) avec des entrées et des sorties, au moins un registre de sortie de modèle test (2) avec une sortie parallèle pour l'alimentation des entrées de la au moins une unité de test (3) avec un modèle test, et une unité d'autotest (1) pour la commande du registre de sortie de modèle test (2) et pour le chargement du registre de sortie de modèle test (2) avec un modèle test qui présente la forme d'une valeur numérique,
**caractérisé en ce que**
l'unité d'autotest (1) est aménagée de telle sorte qu'elle génère le modèle test comme une séquence périodique d'un sous-modèle, qui présente également la forme d'une valeur numérique,
une périodicité maximale du modèle test étant calculée en fonction d'au moins un nombre actif d'entrées de l'unité de test (3) pour une sortie déterminée de l'unité de test (3), le nombre actif étant le nombre d'entrées de l'unité de test (3) sur lesquelles uniquement des modifications peuvent avoir des effets sur la sortie déterminée de l'unité de test (3).

2. Module numérique selon la revendication 1,
**caractérisé en ce que**
le module numérique présente au moins une unité d'analyse (4) pour l'analyse d'une réponse de modèle test s'appliquant sur les sorties de la au moins une unité de test (3).

3. Module numérique selon la revendication 2,
**caractérisé en ce que**
le module numérique présente au moins un registre de lecture de réponse de test qui est relié aux sorties de l'unité de test (3) et est aménagé de telle sorte qu'il peut prendre en charge une réponse de test s'appliquant sur les sorties de l'unité de test (3), au moins dans un mode test du module numérique, et peut la transmettre en série à l'unité d'analyse (4).

4. Module numérique selon la revendication 3,
**caractérisé en ce que**
le module numérique présente des éléments fonctionnels qui sont des registres et sont aménagés de telle sorte qu'ils peuvent être commutés de l'unité d'autatest (1) à au moins un registre de lecture de réponse de test (2).

5. Module numérique selon la revendication 3 ou 4,
**caractérisé en ce que**
l'unité d'autotest (1) est aménagée de telle sorte qu'elle peut charger les registres de sortie de modèle test (2) complètement avec un nouveau modèle test et activer ensuite les registres de lecture de réponse de test de telle sorte qu'ils prennent en charge la réponse de test.

6. Module numérique selon l'une quelconque des revendications 3 à 5,
**caractérisé en ce que**
le registre de lecture de réponse de test est formé par un registre de sortie de modèle test (2) qui présente des entrées qui sont reliées aux sorties d'une unité de test (3).

7. Module numérique selon l'une des revendications 3 à 6,
**caractérisé en ce que**
le registre de lecture de réponse de test est un registre de décalage subdivisé en registres de décalage individuels (12) et est aménagé de telle sorte qu'il peut transmettre en série à l'unité d'analyse (4) le résultat d'un enchaînement OU exclusif entre un signal de sortie du dernier, dans le sens de glissement du registre de décalage, registre de décalage individuel (12) et un signal de sortie d'au moins un autre registre de décalage individuel (12).

8. Module numérique selon l'une des revendications 2 à 7,
**caractérisé en ce que**
l'unité d'analyse (4) est un registre de décalage à réaction constitué de plusieurs registres individuels (12), dont l'entrée peut être alimentée avec le résultat d'un premier enchaînement OU exclusif entre la sortie du dernier, dans le sens de décalage du registre de décalage, registre individuel (12) et la sortie d'au moins un autre registre individuel (12), l'entrée d'au moins un registre individuel (12) pouvant être alimentée avec le résultat d'au moins un second enchaînement OU exclusif entre le résultat du premier enchaînement OU exclusif ou la sortie du registre individuel (12) précédent et un signal de sortie de la au moins une unité de test (3), l'entrée pouvant être alimentée, dans le cas du premier, dans le sens de décalage, registre individuel (12), avec le résultat d'un autre enchaînement OU exclusif entre le résultat du premier enchaînement OU exclusif et un signal de sortie de la au moins une unité de test (3).

9. Module numérique selon l'une quelconque des revendications précédentes,
**caractérisé en ce que**
le registre de sortie de modèle test (2) est un registre de décalage qui est aménagé de telle sorte que le modèle test peut être chargé par l'unité d'autotest (1) en série dans le registre de sortie de modèle test (2).

10. Module numérique selon l'une quelconque des revendications précédentes,
**caractérisé en ce que**
le module numérique présente des éléments fonctionnels qui sont des registres et sont aménagés de telle sorte qu'ils peuvent être commutés par l'unité d'autotest (1) à au moins un registre de sortie de modèle test (2).

11. Module numérique selon l'une quelconque des revendications précédentes,
**caractérisé en ce que**
l'unité d'autotest (1) présente une mémoire (6) et est aménagée de telle sorte qu'elle peut former le modèle test au moyen d'un sous-modèle déposé dans la mémoire (6) comme séquence périodique du sous-modèle avec une périodicité variable.

12. Module numérique selon l'une quelconque des revendications précédentes,
**caractérisé en ce que**
l'unité d'autotest (1) présente un compteur et est aménagée de telle sorte qu'elle peut exploiter le compteur dans le sens de comptage ascendant et/ou descendant et peut former le modèle test au moyen de l'indication du compteur comme sous-modèle.

13. Module numérique selon l'une quelconque des revendications précédentes,
**caractérisé en ce que**
le module numérique présente plusieurs registres de sortie de modèle test (2) et est aménagé de telle sorte que les registres de sortie de modèle test (2) sont chargés simultanément avec le même modèle test.

14. Module numérique selon l'une quelconque des revendications précédentes,
**caractérisé en ce que**
le module numérique présente au moins un registre de décalage de sous-modèle (14) à réaction, qui peut être chargé avec un sous-modèle et est aménagé de telle sorte qu'il peut sortir en série le modèle test comme séquence périodique du sous-modèle.

15. Module numérique selon la revendication 14,
**caractérisé en ce que**
le registre de décalage de sous-modèle (14) est aménagé de telle sorte qu'il peut sortir avec une périodicité variable le modèle test comme séquence périodique du sous-modèle.

16. Module numérique selon la revendication 14 ou 15,
**caractérisé en ce que**
le registre de décalage de sous-modèle (14) est contenu dans l'unité d'autotest (1).

17. Module numérique selon la revendication 14 ou 15,
**caractérisé en ce que**
les registres du registre de sortie de modèle test (2) peuvent être commutés au moins en partie vers le registre de décalage de sous-modèle (14).

18. Module numérique selon la revendication 14 ou 15,
**caractérisé en ce que**
une partie du registre de sortie de modèle test (2) forme le registre de décalage de sous-modèle (14).

19. Module numérique selon l'une quelconque des revendications précédentes,
**caractérisé en ce que**
le registre de sortie de modèle test (2) est câblé avec l'unité de test (3) de telle sorte que les entrées de l'unité de test (3), sur lesquelles seules des modifications ont des effets sur une sortie déterminée de l'unité de test (3), sont situées ensemble le plus près possible par rapport à l'ordre de succession des sorties du registre de sortie de modèle test (2).

20. Module numérique selon l'une ou quelconque des revendications précédentes,
**caractérisé en ce que**
l'unité de test (3) est aménagée de telle sorte que les nombres actifs d'entrées de l'unité de test (3) pour les sorties de l'unité de test (3) sont les plus petits possibles.

21. Module numérique selon l'une quelconque des revendications précédentes,
**caractérisé en ce que**
le module numérique présente des lignes de commande guidées vers l'extérieur pour l'unité d'autotest (1), l'unité d'autotest (1) étant aménagée de telle sorte qu'elle peut être commandée à l'aide d'instructions pouvant être entrées par les lignes de commande.

22. Module numérique comprenant des éléments fonctionnels, qui sont associés à au moins une unité de test (3) avec des entrées et des sorties, au moins un registre de sortie de modèle test (2) avec une sortie parallèle pour l'alimentation des entrées de la au moins une unité de test (3) avec un modèle test, au moins une unité d'analyse (4) pour l'analyse d'une réponse de modèle test s'appliquant sur les sorties de la au moins une unité de test (3) et une unité d'autotest (1) pour la commande du au moins un registre de sortie de modèle test (2) et de l'unité d'analyse (4) et pour le chargement du registre de sortie de modèle test avec le modèle test qui représente la forme d'une valeur binaire,
**caractérisé en ce que**
l'unité d'autotest (1) est aménagée de telle sorte qu'elle génère le modèle test comme conséquence d'au moins un sous-modèle pouvant être sélectionné dans une liste de sous-modèles, le registre de sortie de modèle test (2) étant un registre de décalage, qui peut être chargé en série avec le modèle test, et l'unité d'analyse (4) étant aménagée de telle sorte qu'elle peut analyser la réponse de modèle test lors de chaque cycle avec lequel une nouvelle partie de modèle test est chargée dans le registre de sortie de modèle test (2),
la longueur maximale des sous-modèles étant fonction d'au moins un nombre actif d'entrées d'une unité de test (3) pour une sortie déterminée de l'unité de test (3), le nombre actif étant le nombre d'entrées de l'unité de test (3) sur lesquelles uniquement des modifications ont des conséquences sur la sortie déterminée de l'unité de test (3).

23. Module numérique selon revendication 22,
**caractérisé en ce que**
l'unité d'analyse (4) est un registre de décalage à réaction constitué de plusieurs registres individuels (12), dont l'entrée est alimentée avec le résultat d'un premier enchaînement OU exclusif entre la sortie du dernier, dans le sens du registre de décalage, registre individuel (12) et la sortie d'au moins un autre registre individuel (12) du registre de décalage.

24. Module numérique selon revendications 22 ou 23,
**caractérisé en ce que**
le module numérique présente des éléments fonctionnels qui sont des registres et sont aménagés de telle sorte qu'ils peuvent être commutés de l'unité d'autotest (1) vers le au moins un registre de sortie de modèle test (2).

25. Module numérique selon l'une ou quelconque des revendications 22 à 24,
**caractérisé en ce que**
l'unité d'autotest (1) présente une mémoire (6) et est aménagée de telle sorte qu'elle peut former le modèle test au moyen de sous-modèles déposés dans la mémoire (6).

26. Module numérique selon l'une quelconque des revendications 22 à 25,
**caractérisé en ce que**
l'unité d'autotest (1) présente un compteur et est aménagée de telle sorte qu'elle peut exploiter le compteur dans un sens de comptage ascendant et/ou descendant et peut former le modèle test au moyen des indications de compteur.

27. Module numérique selon l'une ou quelconque des revendications 22 à 26,
**caractérisé en ce que**
le module numérique présente plusieurs registres de sortie de modèle test (2) et est aménagé de telle sorte que les registres de sortie de modèle test (2) sont chargés simultanément avec le même modèle test.

28. Procédé pour tester un module numérique, le composant numérique présentant des éléments fonctionnels qui sont associés à au moins une unité de test (3) avec des entrées et des sorties, au moins un registre de sortie de modèle test (2) avec une sortie parallèle pour l'alimentation des entrées de la au moins une unité de test (3) avec un modèle test et une unité d'autotest (1) pour la commande du registre de sortie de modèle test (2) et pour le chargement du registre de sortie de modèle test (2) avec un modèle test qui présente la forme d'une valeur numérique,
**caractérisé en ce que**
le modèle test est généré comme séquence périodique d'un sous-modèle qui représente également la forme d'une valeur numérique,
**en ce que** le au moins un registre de sortie de modèle test (2) est chargé avec un modèle test, et **en ce que** le comportement à la réponse de la au moins une unité de test (3) est analysé sur le modèle test,
une périodicité maximale du modèle test étant déterminée en fonction d'au moins un nombre actif d'entrées de l'unité de test (3) pour une sortie déterminée de l'unité de test (3), le nombre actif étant le nombre d'entrées de l'unité de test (3), sur lesquelles uniquement des modifications ont des effets sur la sortie déterminée de l'unité de test (3).

29. Procédé pour tester un module numérique, le module numérique présentant des éléments fonctionnels qui sont associés à au moins une unité de test (3) avec des entrées et des sorties, et au moins un registre de sortie de modèle test (2) avec une sortie parallèle pour l'alimentation des entrées de la au moins une unité de test (3) avec un modèle test qui présente la forme d'une valeur numérique, le registre de sortie de modèle test (2) étant conçu comme un registre de décalage,
**caractérisé en ce que**
le registre de sortie de modèle test (2) est chargé en série avec le modèle test, et avec chaque cycle, avec lequel un bit du modèle test est chargé dans le registre de sortie de modèle test (2), on analyse une réponse de modèle test s'appliquant sur les sorties de la au moins une unité de test (3), le modèle test étant généré comme une conséquence d'au moins un sous-modèle pouvant être sélectionné à partir d'une liste de sous-modèles, la longueur maximale de sous-modèles étant fonction d'au moins un nombre actif d'entrées d'une unité de test (3) pour une sortie déterminée de l'unité de test (3), le nombre actif étant le nombre d'entrées de l'unité de test (3) sur lesquelles uniquement des modifications ont des effets sur la sortie déterminée de l'unité de test (3).

30. Procédé selon la revendication 28 ou 29,
**caractérisé en ce que**
pour l'analyse d'une réponse de modèle test dans un registre de décalage à réaction avec plusieurs registres individuels (12), son entrée est alimentée avec le résultat d'un premier enchaînement OU exclusif entre la sortie du dernier, dans le sens de glissement, registre individuel (12) et la sortie d'au moins un autre registre individuel (12) du registre de décalage, l'entrée d'au moins un registre individuel (12) étant alimentée avec le résultat d'au moins un second enchaînement OU exclusif entre le résultat du premier enchaînement OU exclusif ou la sortie de registre individuel (12) précédent et un signal de sortie de l'unité de test (3), l'entrée étant alimentée, dans le cas du premier, dans le sens de glissement, registre individuel (12), avec le résultat d'un autre enchaînement OU exclusif entre le résultat du premier enchaînement OU exclusif et un signal de sortie de l'unité de test (3), de sorte qu'une signature est formée dans le registre de décalage à réaction en fonction de la au moins une sortie de l'unité de test (3).

31. Procédé selon la revendication 28 ou 29,
**caractérisé en ce que**
une réponse de modèle test s'appliquant sur les sorties de la au moins une unité de test (3) est prise en charge à l'aide d'au moins un registre de lecture de modèle test à un moment défini et transmis en série pour l'analyse à une unité d'analyse (4).

32. Procédé selon la revendication 31,
**caractérisé en ce que**
le registre de décalage de modèle test (2) est formé par un registre de sortie de modèle test (2), le contenu du registre de sortie de modèle test (2) étant écrasé lors de la prise en charge de la réponse de modèle test dans un registre de lecture de réponse de modèle test

33. Procédé selon la revendication 32,
**caractérisé en ce que**
chaque registre de sortie de modèle test (2) du modèle numérique sert aussi bien à l'alimentation des entrées de la au moins une unité de test (3) avec un modèle test que comme registre de lecture de réponse de modèle test.

34. Procédé selon la revendication 29 ou 30 et l'une quelconque des revendications 31 à 33,
**caractérisé en ce que**
la réponse de modèle test de l'unité de test (3) est transmise en série au moyen du registre de lecture de modèle test (2) pour la formation de signature au registre de décalage à réaction pour l'analyse, le cycle de sortie série du registre de lecture de modèle test (2) étant identique au cycle de glissement série du registre de décalage à réaction pour l'analyse.

35. Procédé selon la revendication 28 ou 29,
**caractérisé en ce que**
le comportement à la réponse du modèle test de la au moins une unité de test (3) est analysé par le procédé de test à faisceau électronique.

36. Dispositif pour tester un module numérique, le modèle numérique présentant des éléments fonctionnels, qui sont associés à au moins une unité de test (3) avec des entrées et des sorties, au moins un registre de sortie de modèle test (2) avec une sortie parallèle pour l'alimentation des entrées de la au moins une unité de test (3) avec un modèle test, au moins une unité de lecture ou d'analyse pour la lecture ou pour l'analyse d'une réponse de modèle test s'appliquant sur les sorties de la au moins une unité de test (3), et une unité d'autotest (1) pour la commande du registre de sortie de modèle test (2) et de l'unité d'analyse ou de lecture et pour le chargement du registre de sortie de modèle test (2) avec au moins un modèle test qui présente la forme d'une valeur numérique,
le dispositif présentant un appareil de traitement de données pour la génération de données test et une unité de transmission de modèle test qui est aménagée de telle sorte qu'elle peut transmettre des modèles test dans le module numérique pour le chargement dans le au moins un registre de sortie de modèle test (2),
**caractérisé en ce que**
le modèle test est une séquence d'au moins un sous-modèle qui peut être sélectionné dans une liste de sous-modèles ou est une conséquence périodique d'un sous-modèle, le sous-modèle présentant également la forme d'une valeur numérique, et le dispositif étant aménagé de telle sorte que l'appareil de traitement de données génère comme données de modèle test le au moins un sous-modèle et le transmet à l'unité de transmission de modèle test et l'unité de transmission de modèle test génère à partir du au moins un sous-modèle reçu de l'unité de traitement de données le modèle test pour le chargement dans le module numérique,
une périodicité maximale du modèle test ou une longueur maximale du sous-modèle étant déterminée en fonction d'au moins un nombre actif d'entrées de l'unité test (3) pour une sortie déterminée de l'unité de test (3), le nombre actif étant le nombre d'entrées de l'unité de test (3), sur lesquelles uniquement des modifications ont des conséquences sur une sortie déterminée de l'unité de test (3).

37. Dispositif selon la revendication 36,
**caractérisé en ce que**
l'unité de transmission de modèle test est une plaque à aiguille avec des points de contact pour le contact des points de contact sur le module numérique.

38. Dispositif pour tester un module numérique selon la revendication 36,
**caractérisé en ce que**
le dispositif est aménagé de telle sorte qu'il peut transmettre par des lignes de commande sortant du module numérique à l'unité d'autotest (1) à l'intérieur du module numérique des instructions de commande pour générer le au moins un sous-modèle ou des instructions de commande pour la sélection du au moins un sous-modèle à partir de sous-modèles mémorisés ou le au moins un sous-modèle à chaque fois pour générer des modèles test à l'intérieur du module numérique.
